(19) Europäisches Patentamt
European Patent Office
Office européen des brevets

(11) **EP 3 815 469 B1**

(12) **EUROPÄISCHE PATENTSCHRIFT**

(45) Veröffentlichungstag und Bekanntmachung des Hinweises auf die Patenterteilung:
**19.06.2024   Patentblatt 2024/25**

(21) Anmeldenummer: **19748759.8**

(22) Anmeldetag: **17.07.2019**

(51) Internationale Patentklassifikation (IPC):
***H05B 45/00*** *(2022.01)*

(52) Gemeinsame Patentklassifikation (CPC):
**H05B 45/37; G01R 15/183**

(86) Internationale Anmeldenummer:
**PCT/EP2019/069307**

(87) Internationale Veröffentlichungsnummer:
**WO 2020/030394 (13.02.2020 Gazette 2020/07)**

(54) **SYNCHRONE SPERRWANDLERSCHALTUNG ZUM BETRIEB EINER LEUCHTMITTELSTRECKE**

SYNCHRONOUS FLYBACK CONVERTER FOR OPERATING A LIGHTING DEVICE

CONVERTISSEUR INDIRECT SYNCHRONE POUR LE FONCTIONNEMENT D'UN MOYEN D'ÉCLAIRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.08.2018   DE 102018119017**

(43) Veröffentlichungstag der Anmeldung:
**05.05.2021   Patentblatt 2021/18**

(73) Patentinhaber: **Tridonic GmbH & Co KG**
**6851 Dornbirn (AT)**

(72) Erfinder:
• **LOCHMANN, Frank**
**88147 Achberg (DE)**
• **DE CLERCQ, Ludwig Erasmus**
**6850 Dornbirn (AT)**

(74) Vertreter: **Rupp, Christian**
**Mitscherlich PartmbB**
**Patent- und Rechtsanwälte**
**Karlstraße 7**
**80333 München (DE)**

(56) Entgegenhaltungen:
GB-A- 1 488 262          GB-A- 1 488 262
US-A1- 2011 037 414    US-A1- 2011 037 414
US-A1- 2016 033 555    US-A1- 2016 033 555

EP 3 815 469 B1

**Beschreibung**

**1. Gebiet der Erfindung**

Die vorliegende Erfindung betrifft eine synchrone Sperrwandlerschaltung zum Betrieb einer Leuchtmittelstrecke mit wenigstens einem Leuchtmittel, insbesondere mit wenigstens einer Leuchtdiode; eine Leuchte aufweisend eine solche erfindungsgemäße synchrone Sperrwandlerschaltung und eine Leuchtmittelstrecke mit wenigstens einem Leuchtmittel, insbesondere mit wenigstens einer Leuchtdiode; sowie ein Verfahren zum Betreiben einer solchen erfindungsgemäßen synchronen Sperrwandlerschaltung, insbesondere ein Verfahren zum Erfassen des Leuchtmittelstrecken-Stroms bei einer solchen erfindungsgemäßen synchronen Sperrwandlerschaltung.

**2. Hintergrund**

Ein Sperrwandler, auch Hoch-Tiefsetzsteller (englisch "*flyback converter*") genannt, ist ein eingangsseitig aktiv getakteter Gleichspannungswandler bzw. primär getakteter Gleichspannungswandler, der elektrische Energie zwischen einer Eingangsseite bzw. Primärseite und einer Ausgangsseite bzw. Sekundärseite mittels eines Transformators galvanisch entkoppelt bzw. getrennt (also potentialgetrennt) überträgt. Mit einem Sperrwandler kann eine am Eingang zugeführte Gleichspannung in eine Gleichspannung mit einem anderen Spannungsniveau umgewandelt werden.

Eine Sperrwandlerschaltung zum Betreiben einer Leuchtmittelstrecke mit wenigstens einen Leuchtmittelt umfasst daher einen primärseitigen steuerbaren Schalter und einen Transformator mit einer Primärwicklung, welche mit dem steuerbaren Schalter elektrisch verbunden ist, und mit einer Sekundärwicklung. Der Ausgang der Sperrwandlerschaltung ist über eine Diode mit der Sekundärwicklung elektrisch verbunden, wobei die sekundärseitige Diode der Einweggleichrichtung dient.

Die Druckschrift US 2011/037414 A1 offenbart eine Treibervorrichtung, welche zum Betrieb mindestens eines Strangs von Leuchtdioden vorgesehen und konfiguriert ist. Die Treibervorrichtung umfasst einen PFC Sperrwandler, eine Oberwellenfiltereinheit und eine Steuereinheit. Der PFC Sperrwandler arbeitet in einem Betriebsmodus gemäß einem Pulsweitenmodulationssignal (PWM) und empfängt einen Wechselstrom, um diesen in einen pulsierenden Strom umzuwandeln.

Aus dem Stand der Technik ist es nun bekannt die sekundärseitige Diode durch einen sekundärseitigen steuerbaren Schalter zu ersetzen, wodurch eine höhere Effizienz (geringere elektrische Leistungsverluste) erreicht wird. Dieser sekundärseitige steuerbare Schalter kann dann entsprechend der Funktionalität der ersetzten Diode zur Eiweggleichrichtung betrieben werden.

Ein Sperrwandler bzw. eine Sperrwandlerschaltung mit einem sekundärseitigen steuerbaren Schalter anstelle einer Diode zur sekundärseitigen Gleichrichtung werden auch als synchroner Sperrwandler (englisch "*synchronous flyback converter*") bzw. synchrone Sperrwandlerschaltung bezeichnet. Folglich ist in einem synchronen Sperrwandler bzw. in einer synchronen Sperrwandlerschaltung der Ausgang der Sperrwandlerschaltung über einen sekundärseitigen steuerbaren Schalter mit der Sekundärwicklung des Transformators elektrisch verbunden.

Zur Regelung der von einer synchronen Sperrwandlerschaltung am Ausgang bereitgestellten elektrischen Energie oder des am Ausgang bereitgestellten Stroms zum Betreiben einer am Ausgang der synchronen Sperrwandlerschaltung anschließbaren Leuchtmittelstrecke mit wenigstens einem Leuchtmittel muss typischerweise der am Ausgang bereitgestellte Strom und folglich der durch die Leuchtmittelstrecke fließende Strom erfasst werden und als Rückführgröße der entsprechenden Steuereinheit zugeführt werden, die zur Taktung des primärseitigen Schalters vorgesehen ist.

Es ist daher eine Aufgabe der vorliegenden Erfindung, eine synchrone Sperrwandlerschaltung zum Betrieb einer Leuchtmittelstrecke mit wenigstens einem Leuchtmittel bereitzustellen, bei der auf platzsparende und kostengünstige Weise eine Rückführgröße für eine Regelung der ausgangsseitigen zum Betrieb der Leuchtmittelstrecke bereitgestellten elektrischen Energie bzw. des ausgangsseitig bereitgestellten Stroms bereitgestellt werden kann, sodass die synchrone Sperrwandlerschaltung in einen Chip leicht integrierbar ist.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

Die erfindungsgemäße synchrone Sperrwandlerschaltung gemäß dem unabhängigen Anspruch 1 erfüllt die vorstehend genannte Aufgabe, da durch die Erfassungsschaltung der erfindungsgemäßen synchronen Sperrwandlerschaltung auf platzsparende und kostengünstige Weise ein den Leuchtmittelstrecken-Strom widergebendes Signal erzeugt werden kann, das als Rückführgröße dienen kann. Das Gleiche gilt für das entsprechende erfindungsgemäße Verfahren gemäß dem unabhängigen Anspruch 15.

**3. Ausführliche Beschreibung der Erfindung**

Gemäß der vorliegenden Erfindung wird eine synchrone Sperrwandlerschaltung zum Betrieb einer Leuchtmittelstrecke mit wenigstens einem Leuchtmittel, insbesondere mit wenigstens einer Leuchtdiode, bereitgestellt; wobei die synchrone Sperrwandlerschaltung umfasst:

- einen Transformator mit einer Primärwicklung, welche mit einem steuerbaren Schalter elektrisch verbunden ist, und einer Sekundärwicklung, an welche die Leuchtmittelstrecke über einen Ausgang der synchronen Sperrwandlerschaltung anschließbar ist; und

- eine Erfassungsschaltung zur Erzeugung eines Signals, das den durch die Leuchtmittelstrecke fließenden Leuchtmittelstrecken-Strom, wenn die Leuchtmittelstrecke an die Sekundärwicklung angeschlossen ist, wiedergibt. Hierbei trennt der Transformator eine Primärseite der synchronen Sperrwandlerschaltung und eine Sekundärseite der synchronen Sperrwandlerschaltung voneinander galvanisch; wobei die Primärwicklung, der steuerbare Schalter, und die Erfassungsschaltung auf der Primärseite und die Sekundärwicklung und der Ausgang auf der Sekundärseite angeordnet sind. Die Erfassungsschaltung der erfindungsgemäßen synchronen

Sperrwandlerschaltung umfasst:

- eine auf der Primärseite angeordnete Erfassungssekundärwicklung eines Erfassungstransformators, der eine auf der Sekundärseite angeordnete und mit dem Ausgang der synchronen Sperrwandlerschaltung in Reihe elektrisch verbundene Erfassungsprimärwicklung aufweist, wobei der Erfassungstransformator derart eingerichtet ist, dass der Erfassungstransformator durch den Leuchtmittelstrecken-Strom in Sättigung betrieben wird;
- eine Stromquelle, die zum Einspeisen eines sich periodisch verändernden Stroms in die Erfassungssekundärwicklung eingerichtet ist; und
- eine Signalerzeugungseinheit zur Erzeugung des Signals.

Hierbei ist der Erfassungstransformator derart eingerichtet, dass zum Zeitpunkt, zu dem die Sättigung des Erfassungstransformators aufgrund des sich periodisch verändernden Stroms aufgehoben wird, ein Erfassungsimpuls an die Erfassungssekundärwicklung übertragen wird; und die Signalerzeugungseinheit ist dazu eingerichtet, die relative zeitliche Lage wenigstens zweier Erfassungsimpulse in einer Periode des sich periodisch verändernden Stroms als Information bezüglich des Leuchtmittelstrecken-Stroms zur Erzeugung des Signals auszuwerten.

Die vorstehend beschriebene erfindungsgemäße synchrone Sperrwandlerschaltung ist vorteilhaft, da mittels einfacher und kostengünstiger elektrischer Bauteile, wie z.B. eines Erfassungstransformators und einer steuerbaren Stromquelle, Erfassungsimpulse erzeugt werden können, deren relative zeitliche Lage zueinander als Information bezüglich des Leuchtmittelstrecken-Stroms ausgewertet werden kann. Folglich kann bei der erfindungsgemäßen synchronen Sperrwandlerschaltung auf schaltungstechnische einfache und kostengünstige Weise der Leuchtmittelstrecken-Strom als Rückführgröße für eine Regelung der ausgangsseitig bereitgestellten elektrischen Energie bzw. des ausgangsseitig bereitgestellten Stroms zum Betrieb der Leuchtmittelstrecke erfasst werden, wenn die Leuchtmittelstrecke am Ausgang der synchronen Sperrwandlerschaltung angeschlossen ist.

Mit anderen Worten ist die Erfassungsschaltung, insbesondere die Signalerzeugungseinheit, dazu eingerichtet, den zeitlichen Abstand zwischen wenigstens zwei Erfassungsimpulsen in der Periode des sich periodisch verändernden Stroms als Information bezüglich des Leuchtmittelstrecken-Stroms zur Erzeugung des Signals auszuwerten.

Ferner ist die vorstehend beschriebene erfindungsgemäße synchrone Sperrwandlerschaltung vorteilhaft, da sie auf der Primärseite eine potentialgetrennte Erfassung des auf der Sekundärseite fließenden Leuchtmittelstrecken-Stroms ermöglicht.

Wie bereits vorstehend ausgeführt, wird unter einer "*synchronen Sperrwandlerschaltung*" eine "normale" Sperrwanderschaltung verstanden, bei der die zur Gleichrichtung dienende wenigstens eine sekundärseitige Diode durch wenigstens einen sekundärseitigen steuerbaren Schalter ersetzt ist.

Der primärseitige steuerbare Schalter und der wenigstens eine sekundärseitige steuerbare Schalter werden dann vorzugsweise entgegengesetzt angesteuert bzw. getaktet. Mit anderen Worten, wenn der primärseitige steuerbare Schalter leitend geschaltet ist, dann ist vorzugsweise der wenigstens eine sekundärseitige steuerbare Schalter nicht leitend geschaltet; und wenn der primärseitige steuerbare Schalter nicht leitend geschaltet ist, dann ist vorzugsweise der wenigstens eine sekundärseitige steuerbare Schalter leitend geschaltet. Insbesondere wird der wenigstens eine sekundärseitige steuerbare Schalter derart angesteuert, dass er die Funktionalität einer Diode zur Gleichrichtung, also die Funktionalität der in einem "normalen" Sperrwandler sekundärseitig zur Gleichrichtung vorgesehenen Diode erfüllt. Der wenigstens eine sekundärseitige Schalter ist insbesondere mit der Sekundärwicklung des Transformators elektrisch verbunden und verbindet diese mit dem Ausgang der synchronen Sperrwandlerschaltung.

Wie bereits vorstehende ausgeführt, trennt bzw. entkoppelt der Transformator die Primärseite der synchronen Sperrwandlerschaltung von der Sekundärseite der synchronen Sperrwandlerschaltung, sodass eine galvanische Trennung zwischen dem Eingang und dem Ausgang der synchronen Sperrwandlerschaltung besteht. Die synchrone Sperrwandlerschaltung ist also dazu eingerichtet, elektrische Energie zwischen ihrer Primärseite (kann auch als Eingangsseite bezeichnet werden) und ihrer Sekundärseite (kann auch als Ausgangsseite bezeichnet werden) mittels des Transformators potentialgetrennt zu übertragen.

Der auf der Primärseite angeordnete steuerbare Schalter ist vorzugsweise ein Leistungsschalter, ein Feldeffekttransistor, wie z.B. ein Metall-Oxid-Halbleiter-Feldeffekttransistor (MOSFET), oder ein Bipolartransistor. Es können auch andere Schaltertypen, insbesondere Transistortypen, für den primärseitigen steuerbaren Schalter verwendet werden.

Der primärseitige steuerbare Schalter ist vorzugsweise dazu eingerichtet, hochfrequent, insbesondere mit einer Frequenz zwischen 50 kHz und 500 kHz, getaktet zu werden.

Durch Taktung des steuerbaren primärseitigen Schalters und dem dadurch verursachten Laden und Entladen des Transformators kann ausgehend von einer am Eingang der synchronen Sperrwandlerschaltung anschließbaren elektrischen Energiequelle eine am Ausgang der synchronen Sperrwandlerschaltung bereitgestellte elektrische Energie, Strom und/oder Spannung eingestellt werden.

Die synchrone Sperrwandlerschaltung kann eingangsseitig an eine elektrische Energiequelle angeschlossen werden, die der synchronen Sperrwandlerschaltung dann eine Gleichspannung oder eine gleichgerichtete Wechselspannung eingangsseitig bereitstellt.

Die synchrone Sperrwandlerschaltung umfasst also einen primär getakteten Gleichspannungswandler aufweisend den primärseitigen steuerbaren Schalter und den Transformator, wobei der Gleichspannungswandler dazu eingerichtet ist, eine eingangsseitig zugeführte Gleichspannung oder gleichgerichtete Wechselspannung in eine sekundärseitig bereitgestellte Ausgangsspannung mit einem anderen Spannungsniveau zu wandeln.

Die Leuchtmittelstrecke umfasst vorzugsweise ein oder mehrere Leuchtmittel. Die Leuchtmittel sind vorzugsweise in Reihe und/oder parallel miteinander elektrisch verbunden, falls mehr als ein Leuchtmittel in der Leuchtmittelstrecke angeordnet ist. Als Leuchtmittel können alle dem Fachmann bekannten Leuchtmittel verwendet werden, deren Lichtemission durch die dem Leuchtmittel zugeführte elektrische Energie steuerbar ist. Vorzugsweise entspricht das wenigstens eine Leuchtmittel der Leuchtmittelstrecke einer Leuchtdiode (LED), wobei dann die Leuchtmittelstrecke als Leuchtdioden-Strecke mit wenigstens einer Leuchtdiode (LED-Strecke mit wenigstens einer LED) bezeichnet werden kann. Die Leuchtmittelstrecke kann jede Art von LED umfassen, wie z.B. organische LED, anorganische LED, LED mit Sekundäranregung usw. Vorzugsweise umfasst die Leuchtmittelstrecke unterschiedliche Arten von Leuchtmitteln oder nur eine Art von Leuchtmitteln. Die vorliegende Erfindung ist nicht auf ein bestimmtes Leuchtmittel beschränkt.

Der Erfassungstransformator ist insbesondere ein Transformator mit einem Kern, über den die Übertragung der elektrischen Energie ausgehend von der Erfassungsprimärwicklung zu der Erfassungssekundärwicklung erfolgen kann, wenn der Erfassungstransformator sich nicht in Sättigung befindet. Der Kern ist vorzugsweise derart dimensioniert oder gewählt, dass der Erfassungstransformator, insbesondere der Kern des Erfassungstransformators, in Sättigung betrieben wird bzw. sich in Sättigung befindet, wenn der Leuchtmittelstrecken-Strom durch die Erfassungsprimärwicklung fließt. Dies ist vorteilhaft, da die Magnetisierungsverluste sehr gering sind, wenn der Kern derart klein dimensioniert wird, um schnell in Sättigung zu gehen bzw. aufgrund des Leuchtmittelstrecken-Stroms in Sättigung zu gehen.

Unter dem "*Leuchtmittelstrecken-Strom*" wird der Strom verstanden, der durch die Leuchtmittelstrecke fließt, wenn die Leuchtmittelstrecke am Ausgang der synchronen Sperrwandlerschaltung angeschlossen ist.

Wie bereits vorstehend ausgeführt, ist auf der Sekundärseite der synchronen Sperrwandlerschaltung die Erfassungsprimärwicklung mit dem Ausgang der synchronen Sperrwandlerschaltung in Reihe elektrisch verbunden. Folglich ist die Erfassungsprimärwicklung mit der Leuchtmittelstrecke in Reihe elektrisch verbunden, wenn die Leuchtmittelstrecke an den Ausgang angeschlossen ist, und somit fließt der Leuchtmittelstrecken-Strom, der durch die Leuchtmittelstrecke fließt, auch durch die Erfassungsprimärwicklung.

Der Erfassungstransformator ist derart eingerichtet, dass der Erfassungstransformator, insbesondere der Kern des Erfassungstransformators, in Sättigung betrieben wird, wenn der Leuchtmittelstrecken-Strom durch die Erfassungsprimärwicklung fließt.

Der Zustand, bei dem der Erfassungstransformator sich in Sättigung befindet, entspricht dem Zustand, bei dem sich der Kern des Erfassungstransformators in Sättigung befindet.

Während der Erfassungstransformator aufgrund des Leuchtmittelstrecken-Stroms in Sättigung betrieben wird oder sich in Sättigung befindet, wird keine elektrische Energie von der Erfassungsprimärwicklung an die Erfassungssekundärwicklung übertragen.

Ein Erfassungsimpuls entspricht insbesondere einem Stromimpuls oder Strompeak, der an der Erfassungssekundärwicklung zum Zeitpunkt auftritt, zu dem die Sättigung des Erfassungstransformators, insbesondere die Sättigung des Kerns des Erfassungstransformators, aufgrund des sich periodisch verändernden Stroms aufgehoben wird. Als Synonym für Strompeak kann auch der Begriff "Stromspitze" verwendet werden.

Das Wicklungsverhältnis zwischen der Erfassungsprimärwicklung und der Erfassungssekundärwicklung kann 1:1 sein (d.h. die Anzahl der Wicklungen der Erfassungsprimärwicklung kann gleich der Anzahl der Wicklungen der Erfassungssekundärwicklungen sein).

Wenn das Wicklungsverhältnis zwischen der Erfassungsprimärwicklung und der Erfassungssekundärwicklung 1:1 ist, dann ist der Erfassungstransformator vorzugsweise derart eingerichtet, dass zum Zeitpunkt, zu dem der sich periodisch verändernde Strom den Wert des Leuchtmittelstrecken-Stroms erreicht, ein Erfassungsimpuls an die Erfassungssekundärwicklung übertragen wird.

Mit anderen Worten, wenn das Wicklungsverhältnis 1:1 ist, dann entspricht ein Erfassungsimpuls vorzugsweise einem Stromimpuls oder Strompeak, der an der Erfassungssekundärwicklung zum Zeitpunkt auftritt, zu dem der Stromwert des sich periodische verändernden Stroms (der in die Erfassungssekundärwicklung eingespeist wird und folglich diese durchfließt) dem Stromwert des Leuchtmittelstrecken-Stroms (der die Erfassungsprimärwicklung durchfließt) entspricht.

Sobald nämlich der in die Erfassungssekundärwicklung eingespeiste sich periodisch verändernde Strom dem die Erfassungsprimärwicklung durchfließenden Leuchtmittelstrecken-Strom entspricht, heben sich die magnetischen Flüsse in dem Erfassungstransformator auf, wenn die Anzahl der Wicklungen der Erfassungsprimärwicklung gleich der Anzahl der Wicklungen der Erfassungssekundärwicklungen ist.

Aufgrund der Aufhebung der magnetischen Flüsse im Erfassungstransformtor zum Zeitpunkt, zu dem der sich periodisch verändernde Strom dem Leuchtmittestrecken-Strom entspricht, befindet sich der Erfassungstransformator, insbesondere der Kern des Erfassungstransformators, zu diesem Zeitpunkt für eine kurze Zeitdauer nicht in Sättigung. Folglich findet zu diesem Zeitpunkt eine Übertragung von elektrischer Energie ausgehend von der Erfassungsprimärwicklung zur Erfassungssekundärwicklung statt, wodurch zu diesem Zeitpunkt ein Erfassungsimpuls, insbesondere ein Stromimpuls oder Strompeak, an der Erfassungssekundärwicklung auftritt.

Sobald der in die Erfassungssekundärwicklung eingespeiste sich periodisch verändernde Strom dem Leuchtmittelstrecken-Strom nicht mehr entspricht, wird der Erfassungstransformator wieder in Sättigung betrieben bzw. er befindet sich wieder in Sättigung.

Die Anzahl der Wicklungen der Erfassungssekundärwicklung ist vorzugsweise größer als die Anzahl der Wicklungen der Erfassungsprimärwicklung.

Wenn die Anzahl der Wicklungen der Erfassungssekundärwicklung größer als die Anzahl der Wicklungen der Erfassungsprimärwicklung ist, dann tritt vorzugsweise ein Erfassungsimpuls an der Erfassungssekundärwicklung zum Zeitpunkt auf, zu dem der sich periodisch verändernde Strom einen Stromwert erreicht, der entsprechend dem Wicklungsverhältnis kleiner als der Leuchtmittelstrecken-Strom ist.

Zur Erreichung des durch den Leuchtmittelstrecken-Strom an der Erfassungsprimärwicklung verursachten magnetischen Flusses an der Erfassungssekundärwicklung bedarf es nämlich eines kleineren Stromwertes als der Stromwert des Leuchtmittelstrecken-Stroms, wenn die Wicklungszahl der Erfassungssekundärwicklung größer als die Wicklungszahl der Erfassungsprimärwicklung ist.

Der magnetische Fluss MF an einer Wicklung ist nämlich direkt proportional zu dem die Wicklung durchfließenden Strom I und der Wicklungszahl N der Wicklung (MF ~ I · N).

Somit ist der Erfassungstransformator derart eingerichtet, dass er, insbesondere sein Kern, in Sättigung betrieben wird, wenn der Leuchtmittelstrecken-Strom durch die Erfassungsprimärwicklung fließt; und dass ein Erfassungsimpuls an die Erfassungssekundärwicklung zu dem Zeitpunkt übertragen wird, zu dem der an der Erfassungssekundärwicklung durch den sich periodisch verändernden Strom erzeugte magnetische Fluss dem an der Erfassungsprimärwicklung durch den Leuchtmittelstrecken-Strom verursachten magnetischen Fluss entspricht. Zu diesem Zeitpunkt wird nämlich der an der Erfassungsprimärwicklung durch den Leuchtmittelstrecken-Strom verursachte magnetische Fluss durch den an der Erfassungssekundärwicklung durch den sich periodisch verändernden Strom erzeugten magnetischen Fluss aufgehoben, wodurch die Sättigung des Erfassungstransformators, insbesondere des Kerns des Erfassungstransformators, kurzfristig aufgehoben wird.

Der an die Erfassungssekundärwicklung übertragene Erfassungsimpuls entspricht insbesondere einem Spannungsimpuls oder Spannungspeak, der an einer mit der Erfassungssekundärwicklung vorzugsweise elektrisch verbundenen Messeinheit, wie z.B. einem niederohmigen Messwiderstand bzw. Shunt-Widerstand, abgegriffen oder gemessen werden kann. Mit anderen Worten tritt zum Zeitpunkt, zu dem die Sättigung des Erfassungstransformators aufgrund des sich periodisch verändernden Stroms aufgehoben wird, ein Erfassungsimpuls an der Erfassungssekundärwicklung auf, der über die optionale Messeinheit als ein Spannungsimpuls oder Spannungspeak gemessen oder abgegriffen werden kann. Als Synonym für Spannungspeak kann auch der Begriff "Spannungsspitze" verwendet werden.

Vorzugsweise ist die Stromquelle zum Einspeisen eines sich periodisch verändernden Stroms mit einer steigenden Flanke und einer fallenden Flanke während der Periode in die Erfassungssekundärwicklung eingerichtet; und der Erfassungstransformator ist vorzugsweise derart eingerichtet, dass während einer steigenden Flanke ein erster Erfassungsimpuls an die Erfassungssekundärwicklung zum Zeitpunkt übertragen wird, zu dem die Sättigung des Erfassungstransformators aufgrund des sich periodisch verändernden Stroms aufgehoben wird, und dass während einer fallenden Flanke ein zweiter Erfassungsimpuls an die Erfassungssekundärwicklung zum Zeitpunkt übertragen wird, zu dem die Sättigung des Erfassungstransformators aufgrund des sich periodisch verändernden Stroms aufgehoben wird.

Mit anderen Worten ist die Stromquelle vorzugsweise dazu eingerichtet, einen sich periodisch verändernden Strom in die Erfassungssekundärwicklung einzuspeisen, der in jeder Periode eine steigende Flanke und eine fallende Flanke aufweist.

Vorzugsweise steigt der Stromwert des sich periodisch verändernden Stroms von einem Minimalstromwert auf einen Maximalstromwert während der steigenden Flanke an, wobei der Minimalstromwert und Maximalstromwert vorzugsweise derart gewählt sind, dass der Minimalstromwert kleiner als der Stromwert des zu erfassenden Leuchtmittelstrecken-Stroms und der Maximalstromwert größer als der Stromwert des zu erfassenden Leuchtmittelstrecken-Stroms ist. Der Stromwert des sich periodisch verändernden Stroms fällt bzw. verringert sich vorzugsweise von dem Maximalstromwert auf den Minimalstromwert während der fallenden Flanke.

Somit verändert sich vorzugsweise der Stromwert des in die Erfassungssekundärwicklung eingespeisten Stroms periodisch zwischen dem Minimalwert und Maximalwert, wobei während der steigende Flanke der Stromwert ansteigt und während der fallenden Flanke der Stromwert fällt bzw. sich verringert.

Vorzugsweise unterscheiden sich der erste Erfassungsimpuls und der zweite Erfassungsimpuls hinsichtlich ihrer Polarität.

Vorzugsweise entspricht der erste Erfassungsimpuls einem Erfassungsimpuls mit einer positiven Polarität und der zweite Erfassungsimpuls einem Erfassungsimpuls mit einer negativen Polarität.

Insbesondere entspricht der erste Erfassungsimpuls einem Stromimpuls oder Strompeak mit einer positiven Polarität, d.h. einem positiven Stromimpuls oder Strompeak, und der zweite Erfassungsimpuls einem Stromimpuls oder Strompeak mit einer negativen Polarität, d.h. einem negativen Stromimpuls oder Strompeak.

Vorzugsweise kann der erste Erfassungsimpuls über die mit der Erfassungssekundärwicklung vorzugsweise elektrisch verbundene Messeinheit, wie z.B. einem niederohmigen Messwiderstand bzw. Shunt-Widerstand, als ein Spannungsimpuls oder Spannungspeak mit einer positiven Polarität abgegriffen oder gemessen werden, und der zweite Erfassungsimpuls kann vorzugsweise über die mit der Erfassungssekundärwicklung vorzugsweise elektrisch verbundene Messeinheit als ein Spannungsimpuls oder Spannungspeak mit einer negativen Polarität abgegriffen oder gemessen werden.

Ferner ist die Signalerzeugungseinheit vorzugsweise dazu eingerichtet, auf der Basis des während der Periode des sich periodisch verändernden Stroms übertragenen ersten Erfassungsimpuls und zweiten Erfassungsimpuls als Signal ein Signal mit zwei Signalpegeln zu erzeugen, wobei sich zum Zeitpunkt des Auftretens des ersten Erfassungsimpulses das Signal von einem ersten Signalpegel zu einem zweiten Signalpegel ändert, und zum Zeitpunkt des Auftretens des zweiten Erfassungsimpulses das Signal von dem zweiten Signalpegel zu dem ersten Signalpegel ändert.

Vorzugsweise entspricht der erste Signalpegel einem Spannungspegel oder Spannungsniveau, der bzw. das kleiner ist als der Spannungspegel oder das Spannungsniveau des zweiten Signalpegels ist. Dies kann aber auch entsprechend entgegengesetzt sein.

Die Signalerzeugungseinheit ist also vorzugsweise dazu eingerichtet, als Signal ein Spannungssignal zu erzeugen, wobei in jeder Periode des sich periodisch verändernden Stroms eine Pegeländerung vom ersten Spannungspegel auf den zweiten Spannungspegel beim Auftreten des ersten Erfassungsimpulses sowie eine anschließende Pegeländerung vom zweiten Spannungspegel zurück auf den ersten Spannungspegel beim Auftreten des zweiten Erfassungsimpulses erfolgt, wenn in jeder Periode des sich periodisch verändernden Stroms eine steigende Flanke von einer fallenden Flanke gefolgt wird. Dies kann aber auch entsprechend entgegengesetzt sein.

D.h. die Signalerzeugungseinheit kann vorzugsweise auch dazu eingerichtet sein, als Signal ein Spannungssignal zu erzeugen, wobei in jeder Periode des sich periodisch verändernden Stroms eine Pegeländerung vom zweiten Spannungspegel auf den ersten Spannungspegel beim Auftreten des zweiten Erfassungsimpulses sowie eine anschließende Pegeländerung vom ersten Spannungspegel zurück auf den zweiten Spannungspegel beim Auftreten des ersten Erfassungsimpulses erfolgt, wenn in jeder Periode des sich periodisch verändernden Stroms eine fallende Flanke von einer steigenden Flanke gefolgt wird.

Folglich ist die Signalerzeugungseinheit vorzugsweise dazu eingerichtet als Signal ein Rechtecksignal, insbesondere ein Rechteckspannungssignal, zu erzeugen, das sich beim Auftreten des ersten Erfassungsimpulses von dem ersten Signalpegel, insbesondere ersten Spannungspegel, auf den zweiten Signalpegel, insbesondere zweiten Spannungspegel, ändert; und das sich beim Auftreten des zweiten Erfassungsimpulses von dem zweiten Signalpegel, insbesondere zweiten Spannungspegel, auf den ersten Signalpegel, insbesondere ersten Spannungspegel, ändert.

Vorzugsweise ist der Tastgrad des durch die Signalerzeugungseinheit erzeugten Signals ein Maß für den Leuchtmittelstrecken-Strom.

Der Tastgrad des erzeugten Signals, insbesondere des Rechtecksignals, entspricht vorzugsweise dem Verhältnis der Zeitdauer, während der das erzeugte Signal sich auf dem zweiten Signalpegel, insbesondere zweiten Spannungspegel, während der Periode des erzeugten Signals befindet, zu der Periode des erzeugten Signals. Hierbei entspricht die Periode des erzeugten Signals vorzugsweise der Periode des sich periodisch verändernden Stroms.

Insbesondere entspricht der Tastgrad folgender Formel:

$$TG = t_2/P_s,$$

wobei TG der Tastgrad des erzeugten Signals; t2 die Zeitdauer, während der sich das erzeugte Signal auf dem zweiten Pegel während der Periode des erzeugten Signals befindet; und Ps die Periode des erzeugten Signals ist. Der Tastgrad TG entspricht insbesondere dem Verhältnis zwischen der Impulsdauer t2 (während der Periode Ps des erzeugten Signals) und der Periode bzw. Periodendauer Ps des erzeugten Signals.

Je größer der Tastgrad des durch die Signalerzeugungseinheit erzeugten Signals desto niedriger ist vorzugsweise der Leuchtmittelstrecken-Strom.

Vorzugsweise ist die Erfassungsschaltung dazu eingerichtet, den während der Periode des sich periodisch verändernden Stroms übertragenen ersten Erfassungsimpuls und zweiten Erfassungsimpuls pegelmäßig derart zu ändern, dass der während der Periode des sich periodisch verändernden Stroms übertragene erste Erfassungsimpuls und zweite Erfassungsimpuls in positive Spannungsimpulse umgesetzt werden, wobei der Pegel des dem ersten Erfassungsimpuls entsprechenden Spannungsimpulses höher als der Pegel des dem zweiten Erfassungsimpuls entsprechenden Spannungsimpulses ist.

Vorzugsweise ist eine Spannungsquelle in der Erfassungsschaltung vorgesehen, die dazu eingerichtet ist, einem dem ersten Erfassungsimpuls entsprechenden ersten Spannungsimpuls und einem dem zweiten Erfassungsimpuls entsprechenden zweiten Spannungsimpuls eine Gleichspannung als Offsetspannung zu überlagern, sodass der erste Spannungsimpuls, der vorzugsweise einem Spannungsimpuls mit positiver Polarität entspricht, und der zweite Spannungsimpuls, der vorzugsweise einem Spannungsimpuls mit negativer Polarität entspricht, jeweils in einen Spannungsimpuls mit einer positiven Polarität umgesetzt werden.

Der erste Spannungsimpuls ist insbesondere an der mit der Erfassungssekundärwicklung vorzugsweise elektrisch verbundenen Messeinheit zum Zeitpunkt messbar oder abgreifbar, zu dem der erste Erfassungsimpuls auftritt; und der zweite Spannungsimpuls ist insbesondere an der mit der Erfassungssekundärwicklung vorzugsweise elektrisch verbundenen Messeinheit zum Zeitpunkt messbar oder abgreifbar, zu dem der zweite Erfassungsimpuls auftritt.

Folglich ist vorzugsweise an der mit der Erfassungssekundärwicklung vorzugsweise elektrisch verbundenen Messeinheit die Offsetspannung messbar bzw. abgreifbar, während der Erfassungstransformator sich in Sättigung befindet.

Ferner weist die Signalerzeugungseinheit vorzugsweise zwei Komparatoren auf, die mit der Erfassungssekundärwicklung elektrisch verbunden sind; wobei ein erster Komparator der zwei Komparatoren zur Erzeugung eines ersten Komparatorimpulses zum Zeitpunkt des Auftretens des ersten Erfassungsimpulses an der Erfassungssekundärwicklung eingerichtet ist; und wobei ein zweiter Komparator der zwei Komparatoren zur Erzeugung eines zweiten Komparatorimpulses zum Zeitpunkt des Auftretens des zweiten Erfassungsimpulses an der Erfassungssekundärwicklung eingerichtet ist.

Des Weiteren weist die Signalerzeugungseinheit vorzugsweise eine bistabile Kippstufe auf, die mit den zwei Komparatoren elektrisch verbunden ist; wobei der erste Komparator mit dem Setz-Eingang und der zweite Komparator mit dem Rücksetz-Eingang elektrisch verbunden ist; und wobei der nicht negierende Ausgang der bistabilen Kippstufe zum Ausgeben des Signals vorgesehen ist.

Eine bistabile Kippstufe wird auch als Flipflop bezeichnet.

Der Setz-Eingang einer bistabilen Kippstufe wird auch als "Set-Eingang" oder "S-Eingang" bezeichnet. Der Rücksetzt-Eingang einer bistabilen Kippstufe wird auch als "Reset-Eingang" oder "R-Eingang" bezeichnet. Der nicht negierende Ausgang einer bistabilen Kippstufe wird auch als "Q-Ausgang" bezeichnet.

Vorzugsweise weist die synchrone Sperrwandlerschaltung eine auf der Primärseite angeordnete Steuereinheit zur Taktung des primärseitigen steuerbaren Schalters und Steuerung der Stromquelle auf, wobei die Steuereinheit die Stromquelle derart steuert, dass die Frequenz des sich periodisch verändernden Stroms größer als die Frequenz der Taktung des primärseitigen steuerbaren Schalters ist.

Die Steuereinheit ist vorzugsweise ein Prozessor, ein Mikroprozessor, ein Controller, ein Mikrocontroller oder eine anwendungsspezifische integrierte Schaltung (ASIC) oder eine Kombination aus diesen genannten Elementen.

Die Steuereinheit ist vorzugsweise dazu eingerichtet, zusätzlich zu dem primärseitigen steuerbaren Schalter auch wenigstens einen sekundärseitigen steuerbaren Schalter zu steuern, der in einer synchronen Sperrwandlerschaltung auf der Sekundärseite mit der Sekundärwicklung des Transformators zur Gleichrichtung elektrisch verbunden ist.

Insbesondere ist die Steuereinheit dazu eingerichtet, den primärseitigen steuerbaren Schalter und den wenigstens einen sekundärseitigen Schalter entgegengesetzt anzusteuern bzw. zu takten. Mit anderen Worten, die Steuereinheit ist vorzugsweise dazu eingerichtet, den wenigstens einen sekundärseitigen steuerbaren Schalter leitend zu schalten, wenn der primärseitige steuerbare Schalter nicht leitend geschaltet wird; und den wenigstens einen sekundärseitigen steuerbaren Schalter nicht leitend zu schalten, wenn der primärseitige steuerbare Schalter leitend geschaltet wird.

Die Steuereinheit ist insbesondere dazu eingerichtet, den wenigstens einen sekundärseitigen steuerbaren Schalter derart anzusteuern, dass er die Funktionalität einer Diode zur Gleichrichtung, also die Funktionalität der in einem "normalen" Sperrwandler sekundärseitig zur Gleichrichtung vorgesehenen Diode, erfüllt.

Die Steuereinheit ist vorzugsweise dazu eingerichtet, den primärseitigen steuerbaren Schalter auf der Basis von Rückführgrößen, wie z.B. dem Leuchtmittelstrecken-Strom, anzusteuern. Die Erfassungsschaltung ist vorzugsweise dazu eingerichtet, das von ihr erzeugte Signal, das den Leuchtmittelstrecken-Strom widergibt, der Steuereinheit zuzuführen.

Vorzugsweise sind alle Elemente der Erfassungsschaltung, bis auf den Erfassungstransformator, Bestandteile der Steuereinheit. Insbesondere sind alle Elemente der Erfassungsschaltung, bis auf den Erfassungstransformator, in der Steuereinheit integriert.

Vorzugsweise ist der sich periodisch verändernde Strom ein Dreieckstrom.

Vorzugsweise weist die Stromquelle wenigstens einen Bipolartransistor zur Ausgabe des sich periodisch verändernden Stroms auf.

Ferner weist die synchrone Sperrwandlerschaltung vorzugsweise wenigstens eine Impulsverbreiterungsschaltung mit einer Parallelschaltung aus einem Kondensator und einen ohmschen Widerstand und mit einem Komparator auf, wobei der Kondensator und der ohmsche Widerstand derart eingerichtet sind, dass der Kondensator durch einen der Impulsverbreiterungsschaltung zugeführten Impuls während der Dauer des Impulses geladen wird, um anschließend über den ohmschen Widerstand wieder entladen zu werden, wobei der Entladevorgang länger als der Ladevorgang dauert, und wobei der Komparator dazu eingerichtet ist, die an der Parallelschaltung abfallende Spannung mit einem Referenzspannungswert zu vergleichen, der derart kleiner als der Maximalwert bzw. Spitzenwert der Aufladung des Kondensators gewählt ist, dass der durch den Komparator ausgegebene Ausgangsimpuls, während die Spannung an der Parallelschaltung den Referenzspannungswert überschreitet, gegenüber dem zugeführten Impuls verbreitert ist.

Unter einem Verbreitern eines Impulses versteht man insbesondere die Vergrößerung oder Verlängerung der Impulsdauer.

Vorzugsweise, je niedriger der Referenzspannungswert gewählt ist, desto breiter ist der Ausgangsimpuls im Vergleich zum zugeführten Impuls.

Mit anderen Worten, je niedriger bzw. kleiner der Referenzspannungswert gewählt ist, desto länger ist vorzugsweise die Impulsdauer des Ausgangsimpulses im Vergleich zur Impulsdauer des zugeführten Impulses.

Vorzugsweise ist der erste Komparator und/oder der zweite Komparator über die Impulsverbreiterungsschaltung mit der Erfassungssekundärwicklung elektrisch verbunden. Alternativ oder zusätzlich ist der erste Komparator und/oder der zweite Komparator vorzugsweise über die Impulsverbreiterungsschaltung mit der bistabilen Kippstufen elektrisch verbunden.

Insbesondere ist der erste Komparator und der zweite Komparator jeweils über eine eigene Impulsverbreiterungsschaltung mit der bistabilen Kippstufe elektrisch verbunden.

Vorzugsweise ist die Impulsverbreiterungsschaltung in der Erfassungsschaltung vorgesehen, die dazu eingerichtet ist, den ersten Erfassungsimpuls und den zweiten Erfassungsimpuls zu verbreitern, sodass dann ein verbreiteter erster Erfassungsimpuls mit einer längeren Impulsdauer im Vergleich zum ursprünglichen ersten Erfassungsimpuls dem ersten Komparator und ein verbreiteter zweiter Erfassungsimpuls mit einer längeren Impulsdauer im Vergleich zum ursprünglichen zweiten Erfassungsimpuls dem zweiten Komparator zugeführt wird.

Vorzugsweise ist die synchrone Sperrwandlerschaltung auf einer Leiterplatte angeordnet ist, wobei der Erfassungstransformator einen Kern, insbesondere einen Ringkern, zur Übertragung von elektrischer Energie ausgehend von der Erfassungsprimärwicklung zur Erfassungssekundärwicklung aufweist, und der Kern sowie ein Teil der Wicklungen der Erfassungsprimärwicklung und der Erfassungssekundärwicklung vorzugsweise in eine Vertiefung der Leiterplatte eingelegt sind.

Unter einer Vertiefung der Leiterplatte wird eine Kavität in der Leiterplatte verstanden, in der der Erfassungstransformator, insbesondere der Kern und ein Teil der Wicklungen der Erfassungsprimärwicklung und der Erfassungssekundärwicklung angeordnet werden können.

Der Teil der Wicklungen, der in der Vertiefung eingelegt ist, entspricht vorzugsweise den zwischen dem Boden der Vertiefung und dem Kern angeordneten Abschnitten sowie den seitlich am Kern angeordneten Abschnitten der Wicklungen.

In einer bevorzugten Ausführungsform der vorstehend beschriebenen synchronen Sperrwandlerschaltung ist vorzugsweise wenigstens eine Kurzschlussbrücke auf der Erfassungsprimärwicklung und/oder der Erfassungssekundärwicklung angeordnet, und das Wicklungsverhältnis zwischen der Erfassungsprimärwicklung und der Erfassungssekundärwicklung ist vorzugsweise durch die wenigstens eine Kurzschlussbrücke einstellbar.

Eine Kurzschlussbrücke ist auch unter dem Begriff "Jumper" bekannt. Durch das Anordnen der wenigstens einen Kurzschlussbrücke auf der Erfassungsprimärwicklung und/oder der Erfassungssekundärwicklung, wird dann in dem Bereich der Kurzschlussbrücke der in der Vertiefung der Leiterplatte angeordnete Teil der Wicklungen geschlossen. Durch das Schließen des bereits in der Vertiefung der Leiterplatte angeordneten Teils der Wicklungen werden dann Wicklungen der Erfassungsprimärwicklung und/oder der Erfassungssekundärwicklung erzeugt. Hierdurch kann also dann das Wicklungsverhältnis zwischen der Erfassungsprimärwicklung und/oder der Erfassungssekundärwicklung eingestellt werden.

Vorzugsweise ist die wenigstens eine Kurzschlussbrücke dazu eingerichtet, den in der Vertiefung der Leiterplatte angeordneten Teil der Wicklungen der Erfassungsprimärwicklung und/oder der Erfassungssekundärwicklung zu schließen, wodurch die Wicklungszahl der Erfassungsprimärwicklung und/oder der Erfassungssekundärwicklung entsprechend erhöht werden kann.

In einer weiteren bevorzugten Ausführungsform der vorstehend beschriebenen synchronen Sperrwandlerschaltung ist der Kern des Erfassungstransformators vorzugsweise in der Leiterplatte vollkommen integriert, wobei wenigstens eine Leiterbahn vorzugsweise auf der Erfassungsprimärwicklung und/oder der Erfassungssekundärwicklung angeordnet ist, und das Wicklungsverhältnis zwischen der Erfassungsprimärwicklung und der Erfassungssekundärwicklung durch die wenigstens eine Leiterbahn vorzugsweise einstellbar ist.

Vorzugsweise ist die wenigstens eine Leiterbahn dazu eingerichtet, Wicklungen der Erfassungsprimärwicklung und/oder der Erfassungssekundärwicklung zu schließen, wodurch die Wicklungszahl der Erfassungsprimärwicklung oder der Erfassungssekundärwicklung entsprechend erhöht werden kann.

Um die erfindungsgemäße synchrone Sperrwandlerschaltung zu erreichen, können die vorstehenden optionalen Merkmale beliebig kombiniert werden.

Gemäß der vorliegenden Erfindung wird ferner ein Leuchte mit einer erfindungsgemäßen synchronen Sperrwandlerschaltung gemäß den vorstehenden Ausführungen, und mit einer Leuchtmittelstrecke mit wenigstens einem Leuchtmittel, insbesondere mit wenigstens einer Leuchtdiode, bereitgestellt; wobei die synchrone Sperrwandlerschaltung dazu eingerichtet ist, ausgehend von einer eingangsseitig zugeführten Eingangsspannung eine Ausgangsspannung zum Betrieb der Leuchtmittelstrecke ausgangsseitig bereitzustellen.

Die Leuchtmittelstrecke der erfindungsgemäßen Leuchte umfasst vorzugsweise ein oder mehrere Leuchtmittel. Die Leuchtmittel sind vorzugsweise in Reihe und/oder parallel miteinander elektrisch verbunden, falls mehr als ein Leuchtmittel in der Leuchtmittelstrecke angeordnet ist. Als Leuchtmittel können alle dem Fachmann bekannten Leuchtmittel verwendet werden, deren Lichtemission durch die dem Leuchtmittel zugeführte elektrische Energie steuerbar ist. Vorzugsweise entspricht das wenigstens eine Leuchtmittel der Leuchtmittelstrecke einer Leuchtdiode (LED), wobei dann die Leuchtmittelstrecke als Leuchtdioden-Strecke mit wenigstens einer Leuchtdiode (LED-Strecke mit wenigstens einer LED) bezeichnet wird. Die Leuchtmittelstrecke kann jede Art von LED umfassen, wie z.B. organische LED, anorganische LED, LED mit Sekundäranregung usw. Vorzugsweise umfasst die Leuchtmittelstrecke unterschiedliche Arten von Leuchtmitteln oder nur eine Art von Leuchtmitteln. Die vorliegende Erfindung ist nicht auf ein bestimmtes Leuchtmittel beschränkt.

Gemäß der vorliegenden Erfindung wird des Weiteren ein Verfahren zum Erfassen des Leuchtmittelstrecken-Stroms bei einer erfindungsgemäßen synchrone Sperrwandlerschaltung gemäß den vorstehenden Ausführungen, wenn die Leuchtmittelstrecke an die Sekundärwicklung des Transformators der synchronen Sperrwandlerschaltung angeschlossen ist, bereitgestellt; wobei das Verfahren die folgenden Schritte umfasst:

- Einspeisen, mit der Stromquelle, eines sich periodisch verändernden Stroms in die Erfassungssekundärwicklung;

- Übertragen, mit dem Erfassungstransformator, eines Erfassungsimpulses an die Erfassungssekundärwicklung zum Zeitpunkt, zu dem die Sättigung des Erfassungstransformators aufgrund des sich periodisch verändernden Stroms aufgehoben wird; und

- Auswerten, mit der Signalerzeugungseinheit, der relativen zeitlichen Lage wenigstens zweier Erfassungsimpulse in einer Periode des sich periodisch verändernden Stroms als Information bezüglich des Leuchtmittelstrecken-Stroms zur Erzeugung des Signals.

## 4. Beschreibung bevorzugter Ausführungsformen

Nachfolgend wird eine detaillierte Beschreibung der Figuren gegeben. Darin zeigt:

Figur 1      einen schematischen Schaltplan einer bevorzugten Ausführungsform einer erfindungsgemäßen synchronen Sperrwandlerschaltung;

Figur 2      ein Beispiel des zeitlichen Verlaufs des sich periodisch verändernden Stroms sowie von verschiedene Spannungswerten der in Figur 1 gezeigten bevorzugten Ausführungsform einer erfindungsgemäßen synchronen Sperrwandlerschaltung;

Figur 3      einen schematischen Schaltplan einer bevorzugten Ausführungsform einer erfindungsgemäßen Impulsverbreiterungsschaltung;

Figur 4A      ein Beispiel der Verbreiterung von Impulsen durch die in Figur 3 gezeigte bevorzugte Ausführungsform einer erfindungsgemäßen Impulsverbreiterungsschaltung;

Figur 4B      ein Beispiel der Verbreiterung von Impulsen, wenn in der in Figur 1 gezeigten bevorzugten Ausführungsform einer erfindungsgemäßen synchronen Sperrwandlerschaltung der erste und zweite Komparator über jeweils eine erfindungsgemäße Impulsverbreiterungsschaltung mit der bistabilen Kippstufe elektrisch verbunden sind;

Figur 5A      eine bevorzugte Ausführungsform einer Anordnung des Erfassungstransformators der erfindungsgemäßen synchronen Sperrwandlerschaltung bezüglich einer Leiterplatte; und

Figur 5B      eine weitere bevorzugte Ausführungsform einer Anordnung des Erfassungstransformators der erfindungsgemäßen synchronen Sperrwandlerschaltung bezüglich einer Leiterplatte.

**Figur 6**   eine seitliche Ansicht einer bevorzugten Ausführungsform des Erfassungstransformators der erfindungsgemäßen synchronen Sperrwandlerschaltung.

In den Figuren weisen sich entsprechende Elemente identische Bezugszeichen auf.

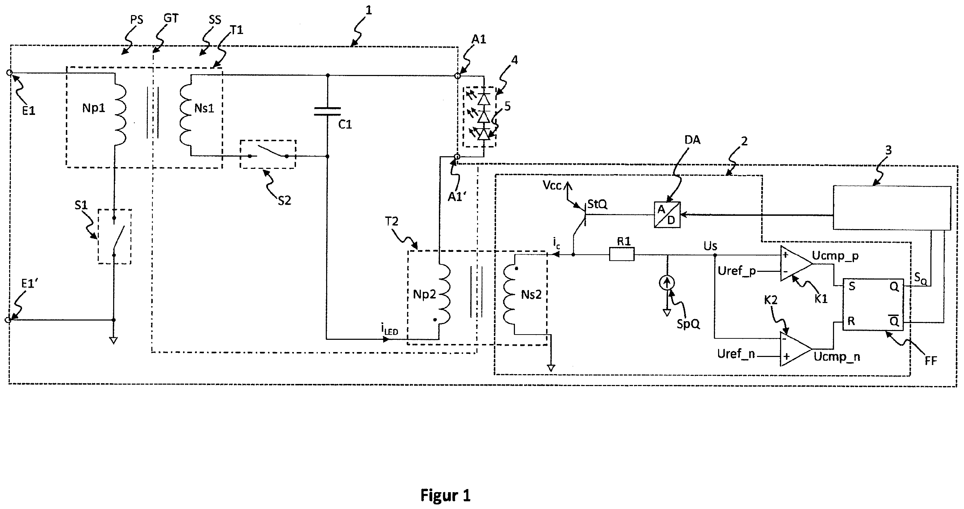

**Figur** 1 zeigt einen schematischen Schaltplan einer bevorzugten Ausführungsform einer erfindungsgemäßen synchronen Sperrwandlerschaltung.

Die synchrone Sperrwandlerschaltung 1 der Figur 1 umfasst einen Transformator T1, der eine galvanische Trennung GT zwischen einer Primärseite PS oder Eingangsseite und einer Sekundärseite SS oder Ausgangsseite der synchronen Sperrwandlerschaltung 1 bereitstellt. Folglich weist die synchrone Sperrwandlerschaltung 1 zwischen ihrem Eingang E1, E1' und ihrem Ausgang A1, A1' eine galvanische Trennung GT auf, die durch den Transformator T1 bereitgestellt wird.

An den Eingang, insbesondere an die wenigstens zwei Eingangsanschlüsse E1 und E1', ist eine elektrische Energiequelle bzw. elektrische Energieversorgung anschließbar (in Figur 1 nicht gezeigt), die der synchronen Sperrwandlerschaltung 1 im angeschlossenen Zustand eingangsseitig eine Gleichspannung oder eine gleichgerichteten Wechselspannung, die vorzugsweise auch geglättet bzw. gesiebt wurde, bereitstellen kann.

An den Ausgang, insbesondere an die wenigstens zwei Ausgangsanschlüssen A1 und A1', ist eine Leuchtmittelstrecke 4 mit wenigstens einem Leuchtmittel 5 anschließbar. Gemäß der Figur 1 umfasst die Leuchtmittelstrecke 4 drei Leuchtmittel 5, erfindungsgemäß kann die Leuchtmittelstrecke 4 aber auch nur ein, zwei oder mehr als drei Leuchtmittel 5 aufweisen.

Wie bereits vorstehend ausgeführt können die Leuchtmittel 4 in Reihe und/oder parallel miteinander elektrisch verbunden sein, falls mehr als ein Leuchtmittel in der Leuchtmittelstrecke angeordnet ist. Als Leuchtmittel 4 können alle dem Fachmann bekannten Leuchtmittel verwendet werden, deren Lichtemission durch die dem Leuchtmittel zugeführte elektrische Energie steuerbar ist. Vorzugsweise entsprechen die Leuchtmittel 5 der Leuchtmittelstrecke 4 einer Leuchtdiode (LED). Die Leuchtmittelstrecke 4 kann jede Art von LED umfassen, wie z.B. organische LED, anorganische LED, LED mit Sekundäranregung usw. Vorzugsweise umfasst die Leuchtmittelstrecke 4 unterschiedliche Arten von Leuchtmitteln oder nur eine Art von Leuchtmitteln.

Die synchrone Sperrwandlerschaltung 1 und die Leuchtmittelstrecke 4 bilden zusammen eine erfindungsgemäße Leuchte.

Auf der Primärseite PS der in Figur 1 gezeigten synchronen Sperrwanderschaltung 1 sind der Eingang, insbesondere die Eingangsanschlüsse E1 und E1'; die Primärwicklung Np1 des Transformators T1; ein steuerbarer Schalters S1; eine Erfassungsschaltung 2 sowie eine Steuereinheit 3 angeordnet.

Der primärseitige Schalter S1 ist mit der Primärwicklung Np1 des Transformators T1 in Reihe elektrisch verbunden.

Auf der Sekundärseite SS der in Figur 1 gezeigten synchronen Sperrwandlerschaltung 1 sind der Ausgang, insbesondere die Ausgangsanschlüsse A1 und A1'; die Sekundärwicklung Ns1 des Transformators T1; ein weiterer steuerbarer Schalter S2; ein optionaler Kondensator C1 und die Erfassungsprimärwicklung Np2 eines Erfassungstransformators T2 angeordnet. Die Erfassungssekundärwicklung Ns2 des Erfassungstransformators T2 ist auf der Primärseite PS, insbesondere als Teil der Erfassungsschaltung 2, angeordnet.

Die Sekundärwicklung Ns1 des Transformators T1 ist über den weiteren steuerbaren Schalter S2 mit dem optionalen Kondensator C1 und der Erfassungsprimärwicklung Np2 des Erfassungstransformators T2 elektrisch verbunden. Insbesondere ist der betragsmäßig potentialniedrigere Anschluss der Sekundärwicklung Ns1 über den weiteren steuerbaren Schalter S2 mit dem betragsmäßig potentialniedrigeren Anschluss des Kondensators C1 und dem betragsmäßig potentialniedrigeren Anschluss der Erfassungsprimärwicklung Np2 elektrisch verbunden. Der weitere steuerbare Schalter S2 kann alternativ auch mit dem betragsmäßig potentialhöheren Anschluss der Sekundärwicklung Ns1 elektrisch verbunden sein.

Die Leuchtmittelstrecke 4, insbesondere die Leuchtmittel 5, können auch komplementär zu der in Figur 1 gezeigten elektrischen Verbindung mit dem Ausgang A1, A1' elektrisch verbunden werden.

Die Erfassungsprimärwicklung Np2 des Erfassungstransformators T2 ist mit dem Ausgang, insbesondere den Ausgangsanschlüssen A1 und A1', in Reihe elektrisch verbunden. Die Sekundärwicklung Ns1, der optionale Kondensator C1 und die Reihenschaltung aus dem Ausgang der synchronen Sperrwandlerschaltung 1 und der Erfassungsprimärwicklung Np2 sind zu einander parallel elektrisch verbunden.

Wenn die Leuchtmittelstrecke 4 an dem Ausgang, insbesondere an den Ausgangsanschlüssen A1 und A1', angeschlossen ist bzw. mit diesem/diesen elektrisch verbunden ist, dann ist die Leuchtmittelstrecke 4 mit der Erfassungsprimärwicklung Np2 des Erfassungstransformators T2 in Reihe elektrisch verbunden. Folglich fließt dann der durch die Leuchtmittelstrecke 4 fließende Leuchtmittelstrecken-Strom $i_{LED}$ auch durch die Erfassungsprimärwicklung Np2.

Wie bereits vorstehend ausgeführt, ist der Erfassungstransformator T2 derart eingerichtet, dass der Erfassungstransformator T2, insbesondere der Kern des Erfassungstransformators T2, in Sättigung betrieben wird bzw. sich in Sättigung befindet, wenn der Leuchtmittelstrecken-Strom $i_{LED}$ durch die Erfassungsprimärwicklung Np2 fließt.

Der optionale Kondensator C1 ist insbesondere ein Glättungskondensator bzw. ein Siebungskondensator.

Auf der Primärseite PS der synchronen Sperrwandlerschaltung 1 sind der primärseitige steuerbare Schalter S1 und die Primärwicklung Np1 des Transformators T1 derart eingerichtet, dass im leitenden Zustand des steuerbaren Schalters S1 ausgehend von einer an den Eingang E1, E1' anschließbaren elektrischen Energiequelle ein Strom durch die Primärwicklung Np1 des Transformtors T1 und den primärseitigen Schalter S1 fließt, wodurch die Primärwicklung Np1 des Transformator T1 mit elektrischer Energie geladen wird. Die elektrische Energie wird dann von der Primärwicklung Np1 zur Sekundärwicklung Ns1, also von der Primärseite PS zur Sekundärseite SS, potentialgetrennt übertragen, wenn der primärseitige steuerbare Schalter S1 ausgeschaltet wird. Die Sekundärwicklung Ns1 wird dann im nicht leitenden Zustand des primärseitigen Schalters S1 entladen.

Hierbei wird der sekundärseitige weitere steuerbare Schalter S2 vorzugsweise komplementär zum primärseitigen steuerbaren Schalter S1 getaktete. Das heißt, wenn der primärseitige steuerbare Schalter S1 leitend geschalten wird, dann wird der sekundärseitige weitere steuerbare Schalter S2 nicht leitend geschaltet; und wenn der primärseitige steuerbare Schalter S1 nicht leitend geschaltet wird, dann wird der sekundärseitige weitere steuerbare Schalter S2 leitend geschaltet.

Der sekundärseitige weitere steuerbare Schalter S2 wird insbesondere derart getaktet bzw. angesteuert, dass er die Funktionalität einer Diode zur Gleichrichtung, insbesondere zur Einweggleichrichtung, bereitstellt.

Folglich dient der primärseitige Schalter S1 vorzugsweise zur Einstellung der am Ausgang der synchronen Sperrwandlerschaltung bereitgestellten elektrischen Energie, Strom und/oder Spannung. Insbesondere kann durch die Taktung des primärseitigen steuerbaren Schalters S1 die Wandlung einer eingangsseitig zugeführten Gleichspannung oder gleichgerichteten Wechselspannung in eine ausgangsseitig bereitgestellte Ausgangsspannung mit einem anderen Spannungsniveau gesteuert werden.

Der sekundärseitige weitere Schalter S2 dient vorzugsweise der Gleichrichtung, insbesondere der Einweggleichrichtung, und der optionale Kondensator C1 dient vorzugsweise der Glättung bzw. Siebung.

Folglich bilden der primärseitige steuerbare Schalter S1, der Transformator T1 mit der Primärwicklung Np1 und der Sekundärwicklung Ns1, der sekundärseitige weitere steuerbare Schalter S2 und der optionale Kondensator C1 einen primär getakteten Spannungswandler, nämlich einen synchronen Sperrwandler.

Der primärseitige steuerbare Schalter S1 und der sekundärseitige weitere steuerbare Schalter S2 sind vorzugsweise ein Leistungsschalter, ein Feldeffekttransistor, wie z.B. ein Metall-Oxid-Halbleiter-Feldeffekttransistor (MOSFET), oder ein Bipolartransistor.

Die primärseitige Steuereinheit 3 ist zur Steuerung des primärseitigen Schalters S1 und des sekundärseitigen Schalters S2 eingerichtet (dies wird in der Figur 1 nicht durch entsprechende Pfeile angedeutet). Hierfür ist die primärseitige Steuereinheit 3 dazu eingerichtet, entsprechende Steuersignale zu erzeugen und diese dem primärseitigen Schalter S1 und dem sekundärseitigen weiteren Schalter S2 zuzuführen. Die Steuerung des sekundärseitigen weiteren Schalters S2 durch die primärseitige Steuereinheit 3 erfolgt hierbei insbesondere galvanisch getrennt bzw. potentialgetrennt, z.B. über einen Optokoppler. Die primärseitige Steuereinheit 3 ist insbesondere dazu eingerichtet, den primärseitigen Schalter S1 und den sekundärseitigen weiteren Schalter S2 gemäß den vorstehenden Ausführungen zu steuern.

Folglich ist die Steuereinheit 3 dazu eingerichtet, die am Ausgang A1, A1' der synchronen Sperrwandlerschaltung 1 bereitgestellte elektrische Energie, Strom und/oder Spannung einzustellen und somit den Betrieb der am Ausgang angeschlossenen Leuchtmittelstrecke 4 zu steuern.

Die Steuereinheit 3 ist insbesondere dazu eingerichtet, den primärseitigen Schalter S1 auf der Basis wenigstens einer Rückführgröße, wie z.B. auf der Basis des Leuchtmittelstrecken-Stroms $i_{LED}$, zu steuern. Hierfür ist die Erfassungsschaltung 2 dazu eingerichtet, ein den Leuchtmittelstrecken-Strom widergebendes Signal $S_Q$ zu erzeugen und dieses der Steuereinheit 3 zuzuführen.

Wie bereits vorstehend ausgeführt kann die Steuereinheit 3 ein Prozessor, ein Mikroprozessor, ein Controller, ein Mikrocontroller oder eine anwendungsspezifische integriert Schaltung (ASIC) oder eine Kombination aus diesen genannten Elementen sein.

Gemäß der Figur 1 ist die Steuereinheit 3 ein Bestandteil der synchronen Sperrwandlerschaltung 1. Alternativ kann die Steuereinheit 3 auch eine externe Steuereinheit sein, d.h. außerhalb der synchronen Sperrwandlerschaltung 1 angeordnet sein.

Gemäß der Figur 1 umfasst die Erfassungsschaltung 2 der synchronen Sperrwandlerschaltung 1 die Erfassungssekundärwicklung Ns2 des Erfassungstransformators T2, eine steuerbare Stromquelle StQ, einen optionalen Digital-Analog-Umsetzer DA, eine Messeinheit R1 in Form eines niederohmigen Messwiderstands, eine optionale Spannungsquelle SpQ, zwei Komparatoren K1 und K2 und eine bistabile Kippstufe FF. Hierbei bilden insbesondere die zwei Komparatoren K1 und K2 sowie die bistabile Kippstufe bzw. der Flipflop FF eine Signalerzeugungseinheit.

Die Stromquelle StQ der synchronen Sperrwandlerschaltung 1 ist dazu eingerichtet, einen sich periodisch verändernden Strom $i_c$, insbesondere einen Dreieckstrom, in die Erfassungssekundärwicklung Ns2 des Erfassungstransformators T2 einzuspeisen. Gemäß der Figur 1 entspricht die Stromquelle StQ einem Bipolartransistor, der über einen Digital-Analog-Umsetzer DA durch die Steuereinheit 3 gesteuert werden kann. Die Steuereinheit 3 ist dazu eingerichtet, die Stromquelle StQ der Erfassungsschaltung 2 derart zu steuern, dass diese einen sich periodisch verändernden Strom in die Erfas-

sungssekundärwicklung $Ns_2$ des Erfassungstransformators T2 einspeist. Die Stromquelle StQ der Erfassungsschaltung 2 kann erfindungsgemäß auch auf eine andere Weise implementiert werden.

Der Erfassungstransformator T2 ist derart eingerichtet, dass zum Zeitpunkt, zu dem der an der Erfassungssekundärwicklung Ns2 durch den sich periodisch verändernden Stroms $i_c$ erzeugte magnetische Fluss den an der Erfassungsprimärwicklung Np2 durch den Leuchtmittelstrecken-Strom $i_{LED}$ erzeugten magnetischen Fluss aufhebt, ein Erfassungsimpuls an der Erfassungssekundärwicklung Ns2 auftritt. Zu diesem Zeitpunkt wird nämlich die durch den Leuchtmittelstrecken-Strom $i_{LED}$ verursachte Sättigung des Erfassungstransformators T2, insbesondere des Kerns des Erfassungstransformators T2, kurzfristig aufgehoben, sodass kurzfristig elektrische Energie von der sekundärseitigen Erfassungsprimärwicklung Np2 zu der primärseitigen Erfassungssekundärwicklung Ns2 übertragen wird, wodurch es an der Erfassungssekundärwicklung Ns2 zu einem Erfassungsimpuls in Form eines Stromimpulses oder Strompeaks kommt.

Somit ist der Erfassungstransformator T2 derart eingerichtet, dass er durch den Leuchtmittelstrecken-Strom $i_{LED}$ in Sättigung betrieben wird; und dass zum Zeitpunkt, zu dem die Sättigung des Erfassungstransformators T2 aufgrund des sich periodisch verändernden Stroms $i_c$ aufgehoben wird, ein Erfassungsimpuls Imp1, Imp2 an die Erfassungssekundärwicklung Ns2 übertragen wird.

Insbesondere umfasst der Erfassungstransformator T2 einen Kern, über den elektrische Energie von der Erfassungsprimärwicklung Np2 zur Erfassungssekundärwicklung Ns2 im ungesättigten Zustand des Erfassungstransformators übertragen werden kann. Hierbei ist der Kern des Erfassungstransformator T2 vorzugsweise derart dimensioniert oder gewählt, dass der Kern durch den Leuchtmittelstrecken-Strom $i_{LED}$ in Sättigung betrieben wird; und dass zum Zeitpunkt, zu dem die Sättigung des Erfassungstransformators T2 aufgrund des sich periodisch verändernden Stroms $i_c$ aufgehoben wird, ein Erfassungsimpuls Imp1, Imp2 an die Erfassungssekundärwicklung Ns2 übertragen wird.

Die Messeinheit $R_1$ in Form eines niederohmigen Messwiderstands bzw. Shuntwiderstands ist mit der Erfassungssekundärwicklung Ns2, insbesondere mit der betragsmäßig potentialhöheren Seite der Erfassungssekundärwicklung Ns2, elektrisch verbunden, sodass beim Auftreten eines Erfassungsimpulses an der Erfassungssekundärwicklung Ns2 ein entsprechender Spannungsimpuls bzw. Spannungspeak an der Messeinheit R1 gemessen oder abgegriffen werden kann. Die Messeinheit R1 kann erfindungsgemäß auch auf eine andere Weise implementiert werden.

Die optionale Spannungsquelle SpQ ist mit der Messeinheit R1 elektrisch verbunden und ist dazu eingerichtet, den an der Messeinheit R1 messbaren oder abgreifbaren Spannungsimpuls, der durch ein Auftreten eines Erfassungsimpulses an der Erfassungssekundärwicklung Ns2 verursacht wird, pegelmäßig, insbesondere durch Überlagerung einer Gleichspannung, derart zu verschieben, dass dieser Spannungsimpuls einem positiven Spannungsimpuls bzw. einem Spannungsimpuls mit positiver Polarität entspricht, unabhängig davon, ob der Erfassungsimpuls während einer steigenden oder fallenden Flanke des sich periodisch verändernden Stroms $i_c$ an der Erfassungssekundärwicklung Ns2 auftritt.

Die Messeinheit R1, die auf einer Seite mit der Erfassungssekundärwicklung Ns2 des Erfassungstransformators T2 elektrisch verbunden ist, ist auf der anderen Seite mit dem ersten Komparator K1 und zweiten Komparator K2, insbesondere mit dem positiven, nicht-invertierenden Eingang des ersten Komparators K1 und dem negativen, invertierenden Eingang des zweiten Komparators K2, elektrisch verbunden.

Folglich sind der erste Komparator K1, insbesondere sein positiver, nicht-invertierender Eingang, und der zweite Komparator K2, insbesondere sein negativer, invertierender Eingang, jeweils über die Messeinheit R1 mit der Erfassungssekundärwicklung Ns2 des Erfassungstransformators T2 elektrisch verbunden.

Vorzugsweise kann gemäß einer Alternative zur der in Figur 1 gezeigten Erfassungsschaltung der Erfassungstransformator T2 zusätzlich zu der Erfassungssekundärwicklung Ns2 (erste Erfassungssekundärwicklung) eine weitere primärseitige Erfassungssekundärwicklung (zweite Erfassungssekundärwicklung) aufweisen, die ebenfalls mit der sekundärseitigen Erfassungsprimärwicklung NS1 gekoppelt und Teil der Erfassungsschaltung ist (in Figur 1 nicht gezeigt). In diesem Fall ist die Messeinheit R1 vorzugsweise auf einer Seite mit der zweiten Erfassungssekundärwicklung elektrisch verbunden und auf der anderen Seite mit dem ersten Komparator K1 und zweiten Komparator K2 elektrisch verbunden, wobei die Stromquelle StQ der synchronen Sperrwandlerschaltung 1 weiterhin dazu eingerichtet ist, einen sich periodisch verändernden Strom $i_c$ in die erste Erfassungssekundärwicklung $Ns_2$ des Erfassungstransformators T2 einzuspeisen.

In dieser optionalen Alternative tritt dann vorzugsweise ein Erfassungsimpuls an der zweiten Erfassungssekundärwicklung zum Zeitpunkt auf, zu dem der an der ersten Erfassungssekundärwicklung durch den sich periodisch verändernden Stroms $i_c$ erzeugte magnetische Fluss den an der Erfassungsprimärwicklung Np2 durch den Leuchtmittelstrecken-Strom $i_{LED}$ erzeugten magnetischen Fluss aufhebt. Zu diesem Zeitpunkt wird nämlich die durch den Leuchtmittelstrecken-Strom $i_{LED}$ verursachte Sättigung des Erfassungstransformators T2, insbesondere des Kerns des Erfassungstransformators, kurzfristig aufgehoben, sodass kurzfristig elektrische Energie von der sekundärseitigen Erfassungsprimärwicklung Np2 zu der zweiten primärseitigen Erfassungssekundärwicklung übertragen wird, wodurch es an der zweiten Erfassungssekundärwicklung zu einem Erfassungsimpuls in Form eines Stromimpulses oder Strompeaks kommt.

In der vorstehend beschriebenen optionalen Alternative ist eine Trennung zwischen dem dem Erfassungstransformator $T_2$ durch die Stromquelle StQ primärseitig zugeführten sich periodisch verändernden Strom, insbesondere Dreieckstrom, und den am Erfassungstransformator primärseitig zum Zeitpunkt der Aufhebung der Sättigung des Erfassungstransformators auftretenden Strompeaks bzw. Stromspitzen nicht notwendig.

Bei der vorstehend beschriebenen optionalen Alternative ist die Messeinheit R1 in Form eines niederohmigen Messwiderstands bzw. Shuntwiderstands mit der zweiten Erfassungssekundärwicklung elektrisch verbunden, sodass beim Auftreten eines Erfassungsimpulses an der zweiten Erfassungssekundärwicklung ein entsprechender Spannungsimpuls bzw. Spannungspeak an der Messeinheit R1 gemessen oder abgegriffen werden kann. Die Messeinheit R1 kann erfindungsgemäß auch auf eine andere Weise implementiert werden.

Auch bei der vorstehend beschriebenen optionalen alternativen Ausgestaltung des Erfassungstransformators kann die optionale Spannungsquelle SpQ mit der Messeinheit R1 elektrisch verbunden sein und ist dazu eingerichtet, den an der Messeinheit R1 messbaren oder abgreifbaren Spannungsimpuls, der durch ein Auftreten eines Erfassungsimpulses an der zweiten Erfassungssekundärwicklung verursacht wird, pegelmäßig, insbesondere durch Überlagerung einer Gleichspannung, derart zu verschieben, dass dieser Spannungsimpuls einem positiven Spannungsimpuls bzw. einem Spannungsimpuls mit positiver Polarität entspricht, unabhängig davon, ob der Erfassungsimpuls während einer steigenden oder fallenden Flanke des sich periodisch verändernden Stroms $i_c$ an der zweiten Erfassungssekundärwicklung auftritt.

Bei der vorstehend beschriebenen optionalen alternativen Ausgestaltung des Erfassungstransformators und folglich alternativen Ausgestaltung der elektrischen Verbindung des Erfassungstransformators mit der Stromquelle StQ und der Messeinheit R1 sind der erste Komparator K1, insbesondere sein positiver, nicht-invertierender Eingang, und der zweite Komparator K2, insbesondere sein negativer, invertierender Eingang, jeweils über die Messeinheit R1 mit der zweiten Erfassungssekundärwicklung des Erfassungstransformators T2 elektrisch verbunden.

Nachfolgend werden wieder die Komponenten der in Figur 1 gezeigten synchronen Sperrwandlerschaltung 1 beschrieben.

Der erste Komparator K1 ist dazu eingerichtet, einen ersten Komparatorimpuls, insbesondere einen ersten Spannungsimpuls mit positiver Polarität, zum Zeitpunkt des Auftretens des ersten Erfassungsimpulses an der Erfassungssekundärwicklung Ns2 zu erzeugen, wobei der erste Erfassungsimpuls einem Erfassungsimpuls entspricht, der während einer steigenden Flanke des sich periodisch verändernden Stroms $i_c$ zum Zeitpunkt auftritt, zu dem die Sättigung des Erfassungstransformators T2 aufgrund des sich periodisch verändernden Stroms $i_c$ aufgehoben wird.

Hierzu wird dem ersten Komparator K1 ein entsprechender Referenzspannungswert Uref_p an seinem negativen, invertierenden Eingang zugeführt.

Der zweite Komparator K2 ist dazu eingerichtet, einen zweiten Komparatorimpuls, insbesondere einen zweiten Spannungsimpuls mit positiver Polarität, zum Zeitpunkt des Auftretens des zweiten Erfassungsimpulses an der Erfassungssekundärwicklung Ns2 zu erzeugen, wobei der zweite Erfassungsimpuls einem Erfassungsimpuls entspricht, der während einer fallenden Flanke des sich periodisch verändernden Stroms $i_c$ zum Zeitpunkt auftritt, zu dem die Sättigung des Erfassungstransformators T2 aufgrund des sich periodisch verändernden Stroms $i_c$ aufgehoben wird.

Hierzu wird dem zweiten Komparator K2 ein entsprechender Referenzspannungswert Uref_n an seinem positiven, nicht-invertierenden Eingang zugeführt.

Die Komparatoren K1 und K2 sind ausgangsseitig mit der bistabilen Kippstufe FF elektrisch verbunden, wobei der Ausgang des ersten Komparators K1 mit dem Setz-Eingang S und der Ausgang des zweiten Komparators K2 mit dem Rücksetz-Eingang R der bistabilen Kippstufe FF elektrisch verbunden sind.

Folglich ist die bistabile Kippstufe FF dazu eingerichtet, an ihrem nicht invertierenden Ausgang Q das den Leuchtmittelstrecken-Strom $i_{LED}$ widergebende Signal $S_Q$ in Form eines Rechtecksignals zu erzeugen. Dieses Rechtecksignal $S_Q$ wird dann der Steuereinheit 3 zugeführt.

Die Steuereinheit 3 kann das zugeführte Signal $S_Q$ digital oder analog verwenden. Bei einer analogen Verwendung wird das Signal $S_Q$ vorzugsweise durch einen Tiefpass gefiltert.

Die Steuereinheit 3 ist vorzugsweise dazu eingerichtet, auf der Basis des ausgehend von der Erfassungsschaltung 2, insbesondere ausgehend von der bistabilen Kippstufe FF, zugeführten Signals $S_Q$ den Leuchtmittelstrecken-Strom $i_{LED}$ zu bestimmen. Hierbei ist die Steuereinheit 3 insbesondere dazu eingerichtet, das Wicklungsverhältnis zwischen der Erfassungsprimärwicklung Np2 und der Erfassungssekundärwicklung Ns2 zu berücksichtigen.

Vorzugsweise ist der Tastgrad des am nicht invertierenden Ausgang Q der bistabilen Kippstufe FF ausgegebenen Rechtecksignals $S_Q$ ein Maß für den Leuchtmittelstrecken-Strom $i_{LED}$. Insbesondere, je größer der Tastgrad des am nicht invertierenden Ausgang Q der bistabilen Kippstufe FF erzeugten Rechtecksignals $S_Q$, desto niedriger ist der Stromwert des Leuchtmittelstrecken-Stroms $i_{LED}$.

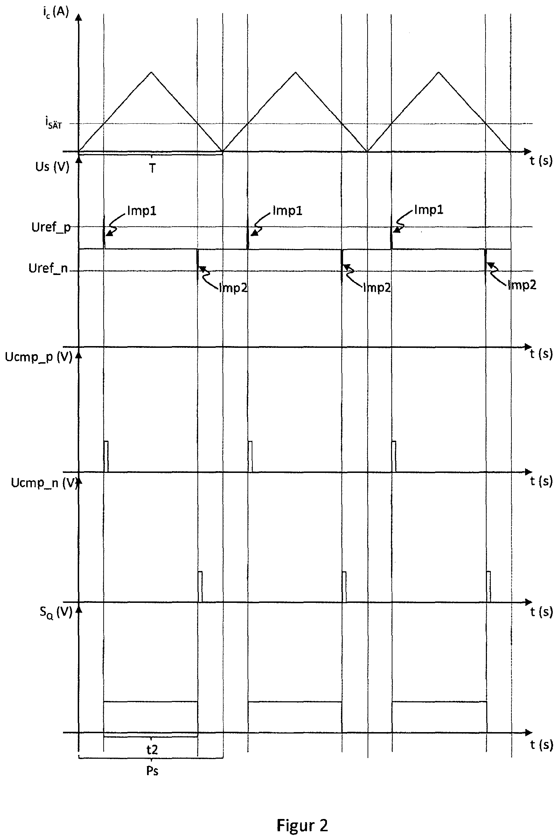

Folglich ist die Erfassungsschaltung 2 dazu eingerichtet, die relative zeitliche Lage wenigstens zweier Erfassungsimpulse in einer Periode des sich periodisch verändernden Stroms $i_c$ als Information bezüglich des Leuchtmittelstrecken-Stroms $i_{LED}$ zur Erzeugung des den Leuchtmittelstrecken-Strom $i_{LED}$ widergebenden Signals $S_Q$ auszuwerten. Der Tastgrad des durch die Erfassungsschaltung 2, insbesondere die Signalerzeugungseinheit, erzeugten Signals (das am nicht invertierenden Ausgang Q der bistabilen Kippstufe FF ausgegebene Signal $S_Q$) ist nämlich abhängig von der relativen zeitlichen Lage des ersten Erfassungsimpulses und des zweiten Erfassungsimpulses in der Periode des sich periodisch verändernden Stroms $i_c$ (vgl. diesbezüglich Figur 2).

Alle Elemente der Erfassungsschaltung 2, bis auf den Erfassungstransformator T2, können Bestandteile der Steuereinheit 3 sein. Insbesondere können alle Elemente der Erfassungsschaltung 2, bis auf den Erfassungstransformator T2, in der Steuereinheit 3 integriert sein. (in Figur 1 nicht gezeigt)

**Figur 2** zeigt schematisch ein Beispiel des zeitlichen Verlaufs des sich periodisch verändernden Stroms sowie von verschiedenen Spannungswerten der in Figur 1 gezeigten bevorzugten Ausführungsform einer erfindungsgemäßen synchronen Sperrwandlerschaltung.

Im obersten Graphen $i_c$ (A) / t (s) wird der zeitliche Verlauf des durch die Stromquelle StQ erzeugten und in die Erfassungssekundärwicklung Ns2 eingespeisten sich periodisch verändernden Stroms $i_c$ gezeigt. Gemäß der Figur 2 entspricht der sich periodisch verändernde Strom $i_c$ einem Dreieckstrom mit einer entsprechenden steigenden Flanke und fallenden Flanke während seiner Periode T. Der Stromwert $i_{SÄT}$ des sich periodisch verändernden Stroms $i_c$, der zum Aufheben der durch den Leuchtmittelstrecken-Strom $i_{LED}$ verursachten Sättigung des Erfassungstransformators T2, insbesondere des Kerns des Erfassungstransformators T2, ausreicht, ist als horizontale gestrichelte Linie $i_{SÄT}$ gezeigt. Durch diese horizontale gestrichelte Linie $i_{SÄT}$ wird also der Stromwert des sich periodisch verändernden Stroms $i_c$ angezeigt, der gemäß dem Wicklungsverhältnis zwischen der Erfassungsprimärwicklung Np2 und der Erfassungssekundärwicklung Ns2 dem Stromwert des Leuchtmittelstrecken-Stroms $i_{LED}$ entspricht. Wenn also das Wicklungsverhältnis 1:1 ist (Anzahl der Wicklungen der Erfassungsprimärwicklung Np2 entspricht der Anzahl der Wicklungen der Erfassungssekundärwicklung Ns2), dann wird durch die horizontale gestrichelte Linie $i_{SÄT}$ der Stromwert des Leuchtmittelstrecken-Stroms $i_{LED}$ angezeigt.

Im zweiten Graphen Us (v) / t (s) ist der zeitliche Verlauf der Spannung, die an der Messeinheit R1 gemessen oder abgegriffen werden kann gezeigt. Zu jedem Zeitpunkt, zu dem der Stromwert des sich periodisch verändernden Stroms $i_c$ dem Stromwert $i_{SÄT}$ entspricht, wird an die Erfassungssekundärwicklung Ns2 des Erfassungstransformators T2 ein Erfassungsimpuls Imp1 oder Imp2 übertragen bzw. tritt an der Erfassungssekundärwicklung Ns2 ein Erfassungsimpuls Imp1 oder Imp2 auf, der über die Messeinheit R1 als ein entsprechender Spannungsimpuls oder Spannungspeak gemessen oder abgegriffen werden kann.

Mit anderen Worten zu jedem Zeitpunkt, zu dem die Sättigung des Erfassungstransformators T2 aufgrund des sich periodisch verändernden Stroms $i_c$ aufgehoben wird, wird an die Erfassungssekundärwicklung Ns2 des Erfassungstransformators T2 ein Erfassungsimpuls Imp1 oder Imp2 übertragen bzw. tritt an der Erfassungssekundärwicklung Ns2 ein Erfassungsimpuls Imp1 oder Imp2 auf, der über die Messeinheit R1 als ein entsprechender Spannungsimpuls oder Spannungspeak gemessen oder abgegriffen werden kann.

Folglich weist zu den Zeitpunkten, zu denen der Stromwert des sich periodisch verändernden Stroms $i_c$ während einer steigenden Flanke den Stromwert $i_{SÄT}$ erreicht, die Spannung Us einen entsprechenden Spannungsimpuls auf, der durch einen ersten Erfassungsimpuls Imp1 mit vorzugsweise positiver Polarität verursacht wurde (wie dies in Figur 2 angedeutet ist). Zu den Zeitpunkten, zu denen der Stromwert des sich periodisch verändernden Stroms $i_c$ während einer fallenden Flanke den Stromwert $i_{SÄT}$ erreicht, weist die Spannung Us einen entsprechenden Spannungsimpuls auf, der durch einen zweiten Erfassungsimpuls Imp2 mit vorzugsweise negativer Polarität verursacht wurde (wie dies in Figur 2 angedeutet ist).

Gemäß der Figur 2 sind sowohl die durch einen ersten Erfassungsimpuls Imp1 verursachten Spannungsimpulse oder Spannungspeaks wie auch die durch einen zweiten Erfassungsimpuls Imp2 verursachten Spannungsimpulse oder Spannungspeak positiv, da diese durch die optionale Spannungsquelle SpQ entsprechend pegelmäßig verschoben wurden. Folglich weisen die den ersten Erfassungsimpulsen Imp1 entsprechenden Spannungsimpulse ein höheres Spannungsniveau auf im Vergleich zu den den zweiten Erfassungsimpulsen Imp2 entsprechenden Spannungsimpulsen. Zu den Zeitpunkten zu denen keine Spannungsimpulse bzw. Spannungspeaks auftreten (also zu denen der sich periodisch verändernde Strom $i_c$ nicht dem Stromwert $i_{SÄT}$ entspricht) entspricht die an der Messeinheit R1 messbare Spannung Us der durch die optionale Spannungsquelle SpQ zur Pegelverschiebung bereitgestellten Offsetspannung.

Aus dem Graphen Us (v) / t (s) ist auch ersichtlich, dass der dem negativen, invertierenden Eingang des ersten Komparators K1 zugeführte Referenzspannungswert Uref_p und der dem positiven, nicht-invertierenden Eingang des zweiten Komparators K2 zugeführte Referenzspannungswert Uref_n derart gewählt sind, dass der erste Komparator K1 am Ausgang einen Spannungsimpuls (erster Komparatorimpuls) beim Auftreten eines ersten Erfassungsimpulses Imp1 an der Erfassungssekundärwicklung Ns2 und folglich beim Auftreten eines entsprechenden Spannungsimpulses an der Messeinheit R1 erzeugt; und dass der zweite Komparator K2 am Ausgang einen Spannungsimpuls (zweiter Komparatorimpuls) beim Auftreten eines zweiten Erfassungsimpulses Imp2 an der Erfassungssekundärwicklung Ns2 und folglich beim Auftreten eines entsprechenden Spannungsimpulses an der Messeinheit R1 erzeugt.

Folglich ist in dem Graphen Ucmp_p (V) / t (s) ersichtlich, dass zu den Zeitpunkten, zu denen der sich periodisch verändernde Strom $i_c$ bei einer steigenden Flanke den Stromwert $i_{SÄT}$ erreicht und folglich zu denen ein erster Erfassungsimpuls Imp1 an die Erfassungssekundärwicklung Ns2 übertragen wird, die am Ausgang des ersten Komparators K1 ausgegebene Spannung Ucmp_p einen ersten Komapratorimpuls aufweist.

In dem Graphen Ucmp_n (V) / t (s) ist ersichtlich, dass zu den Zeitpunkten, zu denen der sich periodisch verändernde Strom $i_c$ bei einer fallenden Flanke den Stromwert $i_{SÄT}$ erreicht und folglich zu denen ein zweiter Erfassungsimpuls Imp2 an die Erfassungssekundärwicklung Ns2 übertragen wird, die am Ausgang des zweiten Komparators K2 ausgegebene Spannung Ucmp_n einen zweiten Komparatorimpuls aufweist.

In dem Graphen $S_Q$ (V) / t(s) ist der zeitliche Verlauf des den Leuchtmittelstrecken-Strom $i_{LED}$ wiedergebenden Signals $S_Q$ gezeigt, das durch die Erfassungsschaltung 2, insbesondere durch die bistabile Kippstufe FF an ihrem nicht invertierenden Ausgang Q, erzeugt wird.

Da der Ausgang des ersten Komparators K1 mit dem Setz-Eingang S der bistabilen Kippstufe FF elektrisch verbunden ist, ändert sich beim Auftreten eines ersten Komparatorimpulses das Signal $S_Q$ von einem ersten Signalpegel oder Spannungspegel zu einem zweiten Signalpegel oder Spannungspegel. Da der Ausgang des zweiten Komparators K2 mit dem Rücksetz-Eingang R der bistabilen Kippstufe FF elektrisch verbunden ist, ändert sich beim Auftreten eines zweiten Komparatorimpulses das Signal $S_Q$ von dem zweiten Signalpegel oder Spannungspegel zu dem ersten Signalpegel oder Spannungspegel.

Folglich ist die Signalerzeugungseinheit, insbesondere der erste Komparator K1, der zweite Komparator K2 und die bistabile Kippstufe FF, dazu eingerichtet, auf der Basis des während der Periode T des sich periodisch verändernden Stroms $i_c$ übertragenen ersten Erfassungsimpulses Imp1 und zweiten Erfassungsimpulses Imp2 als Signal $S_Q$ ein Signal mit zwei Signalpegeln (also ein Rechtecksignal) zu erzeugen, wobei sich zum Zeitpunkt des Auftretens des ersten Erfassungsimpulses Imp1 das Signal $S_Q$ von einem ersten Signalpegel zu einem zweiten Signalpegel ändert, und zum Zeitpunkt des Auftretens des zweiten Erfassungsimpulses Imp2 das Signal $S_Q$ von dem zweiten Signalpegel zu dem ersten Signalpegel ändert.

Wie aus dem Graphen $S_Q$ (V) / t (s) ersichtlich, ist der Tastgrad TG des Signals $S_Q$ ein Maß für den Leuchtmittelstrecken-Strom $i_{LED}$, wobei folgende Beziehung gilt: Je größer der Tastgrad TG des Signals $S_Q$ desto niedriger oder kleiner ist der Stromwert des Leuchtmittelstrecken-Stroms $i_{LED}$. Wie bereits oben ausgeführt, entspricht der Tastgrad TG des Signals $S_Q$ dem Verhältnis der Zeitdauer t2, während der sich das Signal $S_Q$

während seiner Periode Ps auf dem zweiten Signalpegel befindet, zu der Periode Ps des Signals $S_Q$ (TG = t2/Ps). Der Tastgrad TG des Signals $S_Q$ entspricht insbesondere dem Verhältnis der Impulsdauer t2 zu der Periode bzw. Periodendauer Ps des Signals $S_Q$.

Aus Figur 2 ist ersichtlich, dass mit steigendem Leuchtmittelstrecken-Strom $i_{LED}$ (und folglich einer entsprechenden Verschiebung der horizontalen gestrichelten Linie $i_{SÄT}$ im Graphen $i_c$ (A) / t (s) nach oben) der zeitliche Abstand zwischen einem ersten Erfassungsimpuls Imp1 und einem zweiten Erfassungsimpuls Imp2 in der Periode T des sich periodisch verändernden Stroms $i_c$ verkürzt bzw. verkleinert wird, wodurch die Zeitdauer t2, während der das Signal $S_Q$ auf dem zweiten Signalpegel liegt, verkürzt wird und folglich der Tastgrad TG sich verkleinert. Bei einem sinkenden Leuchtmittelstrecken-Strom $i_{LED}$ (und folglich einer entsprechenden Verschiebung der horizontalen gestrichelten Linie $i_{SÄT}$ im Graphen $i_c$ (A) / t (s) nach unten) verlängert bzw. vergrößert sich der zeitliche Abstand zwischen einem ersten Erfassungsimpuls Imp1 und einem zweiten Erfassungsimpuls Imp2 in der Periode T des sich periodisch verändernden Stroms $i_c$, wodurch die Zeitdauer t2, während der das Signal $S_Q$ auf dem zweiten Signalpegel liegt, verlängert wird und folglich der Tastgrad TG sich vergrößert.

Daher kann auf der Basis der relativen zeitlichen Lage wenigstens zweier Erfassungsimpulse, insbesondere der relativen zeitlichen Lage des ersten Erfassungsimpulses Imp1 und des zweiten Erfassungsimpulses Imp2, in der Periode T des sich periodisch verändernden Stroms $i_c$ ein Rückschluss auf den Leuchtmittelstrecken-Strom $i_{LED}$ geschlossen werden. Der zeitliche Abstand zwischen dem ersten Erfassungsimpuls Imp1 und dem zweiten Erfassungsimpuls Imp2 in der Periode T erlaubt nämlich einen Rückschluss auf den Leuchtmittelstrecken-Strom $i_{LED}$. Hierbei wird insbesondere auch das Wicklungsverhältnis zwischen der Erfassungsprimärwicklung Np2 und der Erfassungssekundärwicklung Ns2 berücksichtigt.

Folglich ist die Erfassungsschaltung 2, insbesondere die Signalerzeugungseinheit, dazu eingerichtet, die relative zeitliche Lage wenigstens zweier Erfassungsimpulse in der Periode des sich periodisch verändernden Stroms als Information bezüglich des Leuchtmittelstrecken-Stroms zur Erzeugung des Signals auszuwerten.

Mit anderen Worten ist die Erfassungsschaltung 2, insbesondere die Signalerzeugungseinheit, dazu eingerichtet, den zeitlichen Abstand zwischen wenigstens zwei Erfassungsimpulsen in der Periode des sich periodisch verändernden Stroms als Information bezüglich des Leuchtmittelstrecken-Stroms zur Erzeugung des Signals auszuwerten.

Die Steuereinheit 3, der das durch die Erfassungsschaltung 2 erzeugte Signal $S_Q$ zugeführt wird, kann dann auf der Basis dieses Signals $S_Q$, insbesondere auf der Basis des Tastgrades TG dieses Signals S$_Q$, auf den Leuchtmittelstrecken-Strom i$_{LED}$ zurückschließen oder diesen bestimmen. Hierbei berücksichtigt die Steuereinheit 3 insbesondere auch das Wicklungsverhältnis zwischen der Erfassungsprimärwicklung Np2 und der Erfassungssekundärwicklung Ns2. Folglich kann die Steuereinheit 3 den Leuchtmittelstrecken-Strom als Rückführgröße für eine Steuerung des primärseitigen Schalters S1 verwenden.

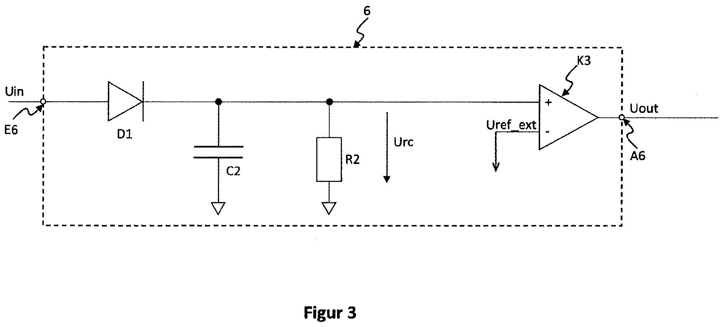

**Figur 3** zeigt einen schematischen Schaltplan einer bevorzugten Ausführungsform einer erfindungsgemäßen Impulsverbreiterungsschaltung.

Die Impulsverbreiterungsschaltung 6 der Figur 3 umfasst eine optionale Diode D1, einen Kondensator C2, einen ohmschen Widerstand R2 sowie einen Komparator K3.

Die optionale Diode D1 ist vorgesehen, um einen Rückfluss ausgehend von den Kondensator C2 im geladenen Zustand zum Eingang E6 der Impulsverbreiterungsschaltung 6 zu verhindern. Folglich ist die Anode der Diode D1 mit dem Eingang E6 elektrisch verbunden.

Der Kondensator C2 und der Widerstand R2 sind parallel zueinander elektrisch verbunden, wobei diese Parallelschaltung aus dem Kondensator C2 und dem Widerstand R2 mit dem positiven, nicht invertierenden Eingang des Komparator K3 und über die optionale Diode D1 mit dem Eingang E6 der Impulsverbreiterungsschaltung 6 elektrisch verbunden ist.

Der Kondensator C2 ist derart eingerichtet, dass er durch einen Spannungspeak bzw. eine Spannungsspitze schneller aufgeladen wird, als dass er nach dem Wegfall des Spannungspeaks über den Widerstand R2 wieder entladen wird. Mit anderen Worten ist die Ladedauer des Kondensator C2 kleiner bzw. schneller als die Entladedauer des Kondensators C2 beim Entladen über den Widerstand R2.

Die an der Parallelschaltung aus Kondensator C2 und Widerstand R2 abfallende Spannung Urc, die während dem Laden des Kondensators C2 eine schnell ansteigende Ladeflanke und während dem Entladen des Kondensators C2 über den Widerstand R2 eine langsamere, insbesondere signifikant langsamere, fallende Entladeflanke aufweist, wird dann dem positiven, nicht-invertierenden Eingang des Komparators K3 zugeführt.

Der am negativen, invertierenden Eingang des Komparators K3 zugeführte Referenzspannungswert Uref_ext ist nun derart niedriger bzw. kleiner als der Maximalwert der Aufladung des Kondensators C2 gewählt, dass der Komparator K3 an seinem Ausgang einen Ausgangsimpuls Uout ausgibt (während die Spannung Urc den Referenzspannungswert Uref_ext überschreitet), der eine längere Impulsdauer aufweist als die Impulsdauer des dem Eingang E6 ursprünglich zugeführten zu verbreiternden Impulses oder Spannungspeaks.

Somit ist die Impulsverbreiterungsschaltung 6 dazu eingerichtet, einen über den Eingang E6 zugeführten Impuls, wie z.B. den vorstehend genannten an die Erfassungssekundärwicklung Ns2 des Erfassungstransformators T2 übertragenen Erfassungsimpuls, insbesondere ersten Erfassungsimpuls und/oder zweiten Erfassungsimpuls, in einen entsprechenden am Ausgang A6 bereitgestellten Ausgangsimpuls Uout umzuwandeln, dessen Impulsdauer länger bzw. größer als die Impulsdauer des ursprünglichen am Eingang E6 zugeführten Impulses ist.

Die synchrone Sperrwandlerschaltung 1, insbesondere die Erfassungsschaltung 2, der Figur 1 weist vorzugsweise wenigstens eine Impulsverbreiterungsschaltung 6 gemäß der Figur 3 auf, wobei diese wenigstens eine Erfassungsschaltung vorzugsweise zwischen der Messeinheit R1 und den beiden Komparatoren K1 und K2 angeordnet ist (in Figur 1 nicht gezeigt).

Folglich ist die wenigstens eine Impulsverbreiterungsschaltung 6 dazu eingerichtet, den an der Messeinheit R1 messbaren Spannungsimpuls zu verbreitern, insbesondere seine Impulsdauer zu verlängern, wenn an die Erfassungssekundärwicklung Ns2 ein Erfassungsimpuls, insbesondere ein erster Erfassungsimpuls oder ein zweiter Erfassungsimpuls, übertragen wird. Dies führt dazu, dass der dem ersten Komparators K1 und zweiten Komparator K2 zugeführte Spannungsimpuls, der einem an der Erfassungssekundärwicklung Ns2 auftretenden ersten Erfassungsimpuls Imp1 entspricht, eine verlängerte Impulsdauer aufweist; und dass der dem ersten Komparator K1 und zweiten Komparators K2 zugeführte Spannungsimpuls, der einem an der Erfassungssekundärwicklung Ns2 auftretenden zweiten Erfassungsimpuls Imp2 entspricht, eine verlängerte Impulsdauer aufweist.

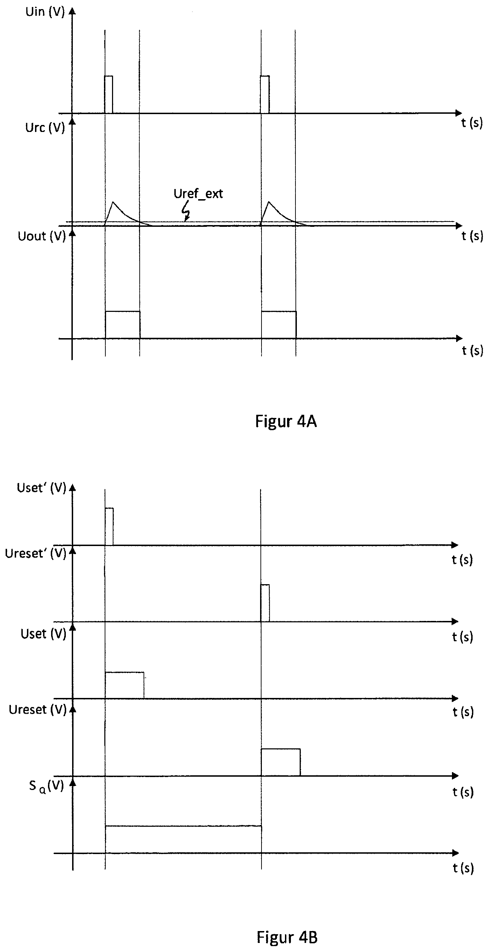

Alternativ oder zusätzlich kann der Ausgang des ersten Komparators K1 über eine Impulsverbreiterungsschaltung 6 gemäß der Figur 3 mit dem Setz-Eingang S der bistabilen Kippstufe FF und der Ausgang des zweiten Komparators K2 über eine weitere Impulsverbreiterungsschaltung 6 gemäß der Figur 3 mit dem Rücksetz-Eingang R der bistabilen Kippstufe FF elektrisch verbunden sein. Die in diesem Fall durch die Komparatoren K1 und K2 der Erfassungsschaltung 2 ausgegebene Spannungsimpulse und die dem Setz-Eingang S und Rücksetz-Eingang R der bistabilen Kippstufe FF zugeführten durch die jeweilige Impulsverbreiterungsschaltung 6 zeitlich verlängerten Spannungsimpulse sind in der Figur 4b schematisch gezeigt.

**Figur 4A** zeigt schematisch ein Beispiel der Verbreiterung von Impulsen durch die in Figur 3 gezeigte bevorzugte Ausführungsform einer erfindungsgemäßen Impulsverbreiterungsschaltung.

Wie aus Figur 4A ersichtlich weist die an der Parallelschaltung aus dem Kondensator C2 und dem Widerstand R2 abfallende Spannung Urc eine steigend Ladeflanke zum Zeitpunkt auf, zu dem die dem Eingang E6 der Impulsverbreiterungsschaltung 6 zugeführte Spannung Uin einen Spannungsimpuls oder einen Spannungspeak aufweist. Durch diesen Spannungspeak bzw. Spannungsspitze wird nämlich der Kondensator C2 geladen. Sobald der eingangsseitig zugeführte Spannungsimpuls abgefallen ist, wird der Ladevorgang des Kondensators C2 beendet und der Kondensator beginnt sich über den Widerstand R2 zu entladen.

Folglich weist die Spannung Ure im Anschluss an die steigende Ladeflanke ein fallende Entladeflanke auf. Hierbei ist die Steilheit der steigenden Ladeflanke steiler bzw. größer als die Steilheit der fallenden Entladeflanke, da der Entladevorgang des Kondensators C2 über den Widerstand R2 langsamer, insbesondere signifikant langsamer, als der vorhergehende Ladevorgang des Kondensators C2 erfolgt.

Wie in Figur 4A ersichtlich, ist nun der dem negativen, invertierenden Eingang des Komparators K3 zugeführte Referenzspannungswert Uref_ext derart kleiner als der Maximalwert der Aufladung des Kondensators C2 gewählt, dass die dem positiven, nicht-invertierenden Eingang zugeführte Spannung Urc größer als der Referenzspannungswert Uref_ext während einer Zeitdauer ist, die länger bzw. größer als die Zeitdauer des Spannungsimpulses der Eingangsspannung Uin der Impulsverbreiterungsschaltung 6 ist.

Folglich wird dann durch den Komparator K3 ein Impuls ausgegeben, der eine längere Impulsdauer aufweist im Vergleich zu dem entsprechenden Impuls der eingangsseitig zugeführt wurde. Dies ist in Figur 4A gut ersichtlich, da die Impulse der Ausgangsspannung Uout eine längere Impulsdauer aufweisen im Vergleich zu den entsprechenden Impulsen der Eingangsspannung Uin.

**Figur 4B** zeigt schematisch ein Beispiel der Verbreiterung von Impulsen, wenn in der in Figur 1 gezeigten bevorzugten Ausführungsform einer erfindungsgemäßen synchronen Sperrwandlerschaltung der erste und zweite Komparator über jeweils eine erfindungsgemäße Impulsverbreiterungsschaltung mit der bistabilen Kippstufe elektrisch verbunden sind.

In der Figur 4B entspricht der zeitliche Verlauf der Spannung Uset' dem zeitlichen Verlauf des durch den ersten Komparator K1 ausgegebenen Spannungssignals und der zeitliche Verlauf der Spannung Ureset' entspricht dem zeitlichen Verlauf des durch den zweiten Komparator K2 ausgegebenen Spannungssignals.

Der zeitliche Verlauf der Spannung Uset entspricht dem zeitlichen Verlauf des Spannungssignals Uset' nachdem die Spannungsimpulse des Spannungssignals Uset' durch die jeweilige erfindungsgemäße Impulsverbreiterungsschaltung verbreitert wurden, wobei dieses Spannungssignal Uset dem Setz-Eingang S der bistabilen Kippstufe FF zugeführt wird.

Der zeitliche Verlauf der Spannung Ureset entspricht dem zeitlichen Verlauf des Spannungssignals Ureset' nachdem die Spannungsimpulse des Spannungssignals Ureset' durch die jeweilige erfindungsgemäße Impulsverbreiterungsschaltung verbreitert wurden, wobei dieses Spannungssignal Ureset dem Rücksetz-Eingang R der bistabilen Kippstufe FF zugeführt wird.

Der zeitliche Verlauf der Spannung $S_Q$ entspricht dem zeitlichen Verlauf des Spannungssignals, dass durch den nicht invertierenden Ausgang Q der bistabilen Kippstufe FF erzeugt wird.

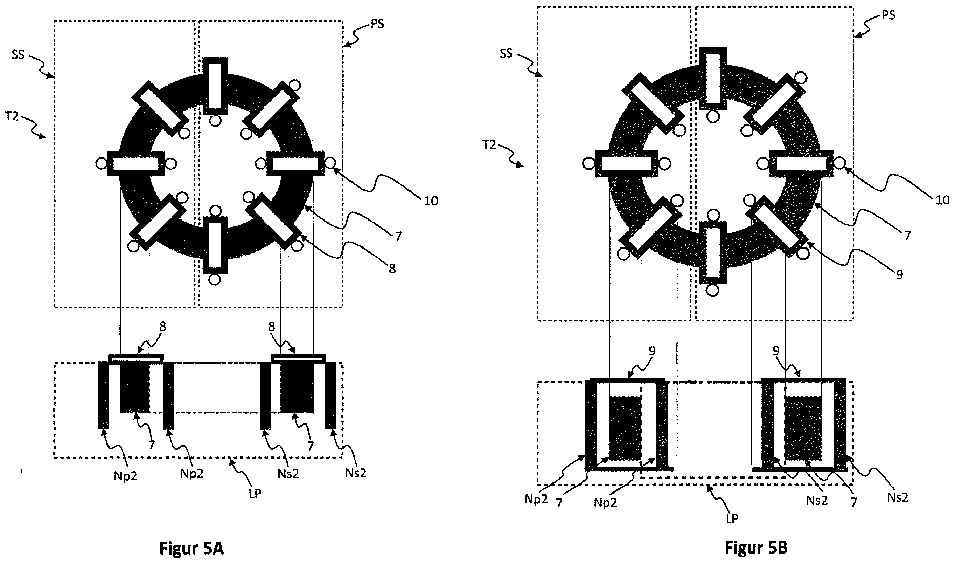

**Figur 5A** zeigt schematisch eine bevorzugte Ausführungsform einer Anordnung des Erfassungstransformators der erfindungsgemäßen synchronen Sperrwandlerschaltung bezüglich einer Leiterplatte. Die Figur 5A zeigt insbesondere schematisch eine Draufsicht (obere Darstellung der Figur 5A) sowie einen Querschnitt (untere Darstellung der Figur 5A) einer bevorzugten Ausführungsform einer Anordnung des Erfassungstransformators der erfindungsgemäßen synchronen Sperrwandlerschaltung bezüglich einer Leiterplatte.

Gemäß der Figur 5A ist ein Ausschnitt einer Leiterplatte LP gezeigt auf der die erfindungsgemäße synchrone Sperrwandlerschaltung angeordnet ist. Figur 5A zeigt schematisch die Anordnung des Erfassungstransformators T2 dessen Primärwicklung Np2 auf der Sekundärseite SS und dessen Sekundärwicklung Ns2 auf der Primärseite PS der synchronen Sperrwandlerschaltung angeordnet ist. Der Erfassungstransformator T2 der Figur 5A umfasst einen Kern 7, insbesondere einen Ringkern, über den elektrische Energie ausgehend von der Erfassungsprimärwicklung NP2 an die Erfassungssekundärwicklung Ns2 potentialgetrennt übertragen werden kann.

Der Kern 7 des Erfassungstransformators T2 ist insbesondere derart dimensioniert, dass der Erfassungstransformator T2, insbesondere der Kern 7, in Sättigung betrieben wird bzw. sich in Sättigung befindet, wenn ein Leuchtmittelstrecken-Strom durch die sekundärseitige Erfassungsprimärwicklung Np2 fließt.

Der Kern 7 sowie ein Teil der Wicklungen der Erfassungsprimärwicklung Np2 und der Erfassungssekundärwicklung Ns2 sind in eine Vertiefung bzw. Kavität der Leiterplatte LP eingelegt.

Die Wicklungen werden dann geschlossen, indem bei der Fertigung nach dem Einlegen des Kerns 7 und dem Teil der Wicklungen, insbesondere dem unteren Teil der Wicklungen, in die Vertiefung der Leiterplatte LP die Wicklungen durch Kurzschlussbrücken 8 geschlossen werden. Hierdurch wird der Kern 7 durch den bereits in der Kavität eingelegten Teil der Wicklungen (unteren Teil der Wicklungen) und die Kurzschlussbrücken 8 umschlossen, sodass dann die Erfassungsprimärwicklung Np2 und Erfassungssekundärwicklung am Kern 7 ausgebildet werden. Eine Kurzschlussbrücke wird auch als Jumper bezeichnet und entspricht insbesondere einer überbrückenden Leitung die von oben auf die Wicklungen aufgesetzt wird, um in dem Bereich der überbrückenden Leitung die Wicklungen zu schließen. Folglich kann durch eine Kurzschlussbrücke der bereits in der Vertiefung der Leiterplatte LP angeordnete Teil der Wicklungen geschlossen werden, um Wicklungen der Erfassungsprimärwicklung Np2 und/oder der Erfassungssekundärwicklung Ns2 zu erzeugen.

Insbesondere werden die Wicklungen des Erfassungstransformators T2 derart gebildet, dass am Boden der Vertiefung der Leiterplatte LP die Wicklungen der Erfassungsprimärwicklung Np2 und/oder der Erfassungssekundärwicklung Ns2 durch eine entsprechende leitende Schicht gebildet werden; und dass die Wicklungen auf der gegenüberliegenden Seite durch eine oder mehrere Kurzschlussbrücken 8 gebildet werden.

Mit anderen Worten werden zwischen dem Boden der Vertiefung und dem Kern 7, d.h. unterhalb des Kerns 7, die Wicklungen durch eine entsprechende leitende Schicht gebildet; und auf der gegenüberliegenden Seite des Kerns 7, d.h. oberhalb des Kerns, werden die Wicklungen dann durch eine oder mehrere Kurzschlussbrücken 8 geschlossen bzw. gebildet.

Die leitende Schicht kann vorzugsweise eine innere Schicht oder die unterste bzw. äußerste Schicht der Leiterplatte sein, wenn die Leiterplatte mehrere leitende Schichten umfasst.

Gemäß der Figur 5A sind zur Erzeugung der Wicklungen der Erfassungsprimärwicklung Np2 drei Kurzschlussbrücken 8 vorgesehen und zur Erzeugung der Wicklungen der Erfassungssekundärwicklung Ns2 fünf Kurzschlussbrücken 8 vorgesehen. Folglich ist bei dem in Figur 5A gezeigten Erfassungstransformator T2 die Anzahl an Wicklungen der Erfassungssekundärwicklung Ns2 größer als die Anzahl an Wicklungen der Erfassungsprimärwicklung Np2. Die Anzahl an Wicklungen der Erfassungssekundärwicklung Ns2 und die Anzahl an Wicklungen der Erfassungsprimärwicklung Np2 kann auch zu der in Figur 5A gezeigten Anzahl unterschiedlich sein.

Durch Kurzschlussbrücken 8 kann also das Wicklungsverhältnis zwischen der Erfassungsprimärwicklung Np2 und der Erfassungssekundärwicklung Ns2 auf einfache Weise eingestellt werden.

Die Kurzschlussbrücken sind vorzugsweise durch Aufstecken in entsprechende Löcher 10 der Leiterplatte LP auf einfache Weise montierbar.

**Figur 5B** zeigt schematisch eine weitere bevorzugte Ausführungsform einer Anordnung des Erfassungstransformators der erfindungsgemäßen synchronen Sperrwandlerschaltung bezüglich einer Leiterplatte. Die Figur 5B zeigt insbesondere schematisch eine Draufsicht (obere Darstellung der Figur 5B) sowie einen Querschnitt (untere Darstellung der Figur 5B) einer bevorzugten Ausführungsform einer Anordnung des Erfassungstransformators der erfindungsgemäßen synchronen Sperrwandlerschaltung bezüglich einer Leiterplatte.

Die in Figur 5B schematisch gezeigte Anordnung des Erfassungstransformators T2 entspricht im Wesentlichen der in Figur 5A schematisch gezeigten Anordnung des Erfassungstransformators T2. Folglich sind die vorstehenden Ausführungen zur Figur 5A auch für die Figur 5B zutreffend. Nachfolgend wird daher auf die Unterschiede zwischen der Figur 5B und Figur 5A eingegangen.

Gemäß der Figur 5B ist der Erfassungstransformator T2, und folglich der Kern 7 und die Wicklungen der Erfassungsprimärwicklung Np2 und der Erfassungssekundärwicklung Ns2 in der Leiterplatte vollkommen integriert.

D.h. der Kern 7 und die Wicklungen der Erfassungsprimärwicklung Np2 und der Erfassungssekundärwicklung Ns2 sind komplett in einer Vertiefung der Leiterplatte LP eingelegt.

Hierbei werden die Wicklungen des Erfassungstransformators T2 insbesondere derart gebildet, dass am Boden der Vertiefung der Leiterplatte die Wicklungen der Erfassungsprimärwicklung Np2 und/oder der Erfassungssekundärwicklung Ns2 durch eine entsprechende leitende Schicht gebildet werden; und dass die Wicklungen auf der gegenüberliegenden Seite durch eine oder mehrere Leiterbahnen 9 gebildet werden.

Mit anderen Worten werden zwischen dem Boden der Vertiefung und dem Kern 7, d.h. unterhalb des Kerns 7, die Wicklungen durch eine entsprechende leitende Schicht gebildet; und auf der gegenüberliegenden Seite des Kerns 7, d.h. oberhalb des Kerns, werden die Wicklungen dann durch eine oder mehrere Leiterbahnen 9 geschlossen bzw. gebildet.

Die leitende Schicht kann vorzugsweise eine innere Schicht oder die unterste bzw. äußerste Schicht der Leiterplatte sein, wenn die Leiterplatte mehrere leitende Schichten umfasst.

Gemäß der Figur 5B sind zur Erzeugung der Wicklungen der Erfassungsprimärwicklung Np2 drei Leiterbahnen 9 vorgesehen und zur Erzeugung der Wicklungen der Erfassungssekundärwicklung Ns2 fünf Leiterbahnen 9 vorgesehen. Folglich ist bei dem in Figur 5B gezeigten Erfassungstransformator T2 die Anzahl an Wicklungen der Erfassungssekundärwicklung Ns2 größer als die Anzahl an Wicklungen der Erfassungsprimärwicklung Np2. Die Anzahl an Wicklungen der Erfassungssekundärwicklung Ns2 und die Anzahl an Wicklungen der Erfassungsprimärwicklung Np2 kann auch zu der in Figur 5B gezeigten Anzahl unterschiedlich sein.

Durch Leiterbahnen 9 kann also das Wicklungsverhältnis zwischen der Erfassungsprimärwicklung Np2 und der Erfassungssekundärwicklung Ns2 auf einfache Weise eingestellt werden.

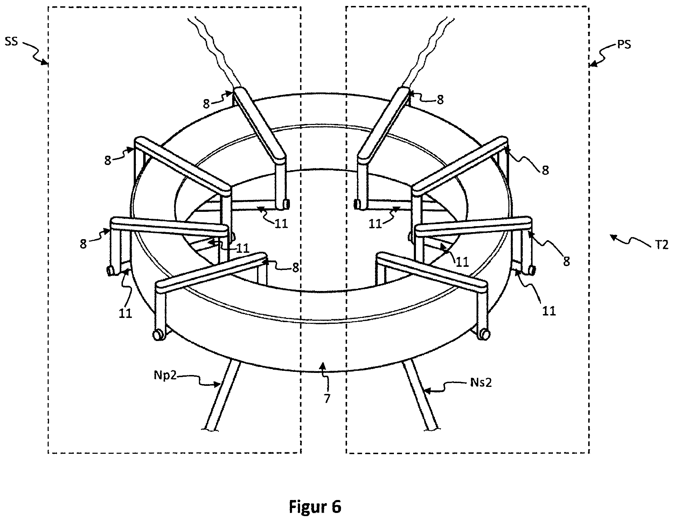

**Figur 6** zeigt schematische eine seitliche Ansicht einer bevorzugten Ausführungsform des Erfassungstransformators der erfindungsgemäßen synchronen Sperrwandlerschaltung.

Die Bildung von Wicklungen der Erfassungsprimärwicklung Np2 und der Erfassungssekundärwicklung Ns2 des in Figur 6 gezeigten Erfassungstransformators T2 wird durch das bereits bezüglich der Figur 5A beschriebenen Prinzip erreicht, d.h. unter dem Einsatz von Kurzschlussbrücken 8 bzw. Jumpers.

Der Kern 7 des Erfassungstransformators T2 ist insbesondere derart dimensioniert, dass der Erfassungstransformator T2, insbesondere der Kern 7, in Sättigung betrieben wird bzw. sich in Sättigung befindet, wenn ein Leuchtmittelstrecken-Strom durch die sekundärseitige Erfassungsprimärwicklung Np2 fließt.

Der Kern 7 sowie ein Teil 11 der Wicklungen der Erfassungsprimärwicklung Np2 und der Erfassungssekundärwicklung Ns2 sind in eine Vertiefung bzw. Kavität einer Leiterplatte (Leiterplatte ist in Figur 6 nicht gezeigt) eingelegt.

Die Wicklungen werden dann geschlossen, indem bei der Fertigung nach dem Einlegen des Kerns 7 und dem Teil 11 der Wicklungen, insbesondere dem unteren Teil 11 der Wicklungen, in die Vertiefung der Leiterplatte die Wicklungen durch Kurzschlussbrücken 8 geschlossen werden. Hierdurch wird der Kern 7 durch den bereits in der Kavität eingelegten Teil 11 der Wicklungen (unteren Teil der Wicklungen) und die Kurzschlussbrücken 8 (oberen Teil der Wicklungen) umschlossen, sodass dann die Erfassungsprimärwicklung Np2 und Erfassungssekundärwicklung am Kern 7 ausgebildet werden.

Eine Kurzschlussbrücke 8 wird auch als Jumper bezeichnet und entspricht insbesondere einer überbrückenden Leitung die von oben auf den bereits vorhandenen Teil 11 der Wicklungen aufgesetzt wird, um in dem Bereich der überbrückenden Leitung die Wicklungen zu schließen. Folglich kann durch eine Kurzschlussbrücke 8 der bereits in der Vertiefung der Leiterplatte angeordnete Teil 11 der Wicklungen geschlossen werden, um Wicklungen der Erfassungsprimärwicklung Np2 und/oder der Erfassungssekundärwicklung Ns2 zu erzeugen.

Insbesondere werden die Wicklungen des Erfassungstransformators T2 derart gebildet, dass am Boden der Vertiefung der Leiterplatte die Wicklungen der Erfassungsprimärwicklung Np2 und/oder der Erfassungssekundärwicklung Ns2 durch eine entsprechende leitende Schicht 11 gebildet werden; und dass die Wicklungen auf der gegenüberliegenden Seite durch eine oder mehrere Kurzschlussbrücken 8 gebildet werden.

Mit anderen Worten werden vorzugsweise zwischen dem Boden der Vertiefung und dem Kern 7, d.h. unterhalb des Kerns 7, die Wicklungen durch eine entsprechende leitende Schicht 11 gebildet; und auf der gegenüberliegenden Seite des Kerns 7, d.h. oberhalb des Kerns, werden die Wicklungen dann durch eine oder mehrere Kurzschlussbrücken 8 geschlossen bzw. gebildet.

Die leitende Schicht kann vorzugsweise eine innere Schicht oder die unterste bzw. äußerste Schicht der Leiterplatte sein, wenn die Leiterplatte mehrere leitende Schichten umfasst.

Gemäß der Figur 6 sind zur Erzeugung der Wicklungen der Erfassungsprimärwicklung Np2 vier Kurzschlussbrücken 8 vorgesehen und zur Erzeugung der Wicklungen der Erfassungssekundärwicklung Ns2 ebenfalls vier Kurzschlussbrücken 8 vorgesehen. Folglich ist bei dem in Figur 6 gezeigten Erfassungstransformator T2 die Anzahl an Wicklungen der Erfassungssekundärwicklung Ns2 gleich der Anzahl an Wicklungen der Erfassungsprimärwicklung Np2. Die Anzahl an Wicklungen der Erfassungssekundärwicklung Ns2 und die Anzahl an Wicklungen der Erfassungsprimärwicklung Np2 kann auch zu der in Figur 6 gezeigten Anzahl unterschiedlich sein.

Durch Kurzschlussbrücken 8 kann also das Wicklungsverhältnis zwischen der Erfassungsprimärwicklung Np2 und der Erfassungssekundärwicklung Ns2 auf einfache Weise eingestellt werden.

Die vorstehend beschriebenen Methoden zur Bildung bzw. Erzeugung der Erfassungsprimärwicklung Np2 und der Erfassungssekundärwicklung Ns2 des Erfassungstransformators T2 können vorzugsweise auch zur Bildung bzw. Erzeugung der Primärwicklung Np1 und Sekundärwicklung Ns1 des Transformators T1 der erfindungsgemäßen synchronen Sperrwandlerschaltung verwendet werden.

**Patentansprüche**

1. Synchrone Sperrwandlerschaltung (1) zum Betrieb einer Leuchtmittelstrecke (4) mit wenigstens einem Leuchtmittel (5), insbesondere mit wenigstens einer Leuchtdiode, wobei die synchrone Sperrwandlerschaltung (1) umfasst:

   - einen Transformator (T1) mit einer Primärwicklung (Np1), welche mit einem steuerbaren Schalter (S1) elektrisch verbunden ist, und einer Sekundärwicklung (Ns1), an welche die Leuchtmittelstrecke (4) über einen Ausgang (A1, A1') der synchronen Sperrwandlerschaltung (1) anschließbar ist, und

   - eine Erfassungsschaltung (2) zur Erzeugung eines Signals ($S_Q$), das den durch die Leuchtmittelstrecke (4) fließenden Leuchtmittelstrecken-Strom ($i_{LED}$), wenn die Leuchtmittelstrecke (4) an die Sekundärwicklung (Ns1) angeschlossen ist, wiedergibt;

   - wobei der Transformator (T1) eine Primärseite (PS) der synchronen Sperrwandlerschaltung (1) und eine Sekundärseite (SS) der synchronen Sperrwandlerschaltung (1) voneinander galvanisch trennt;

   - wobei die Primärwicklung (Np1), der steuerbare Schalter (S1), und die Erfassungsschaltung (2) auf der Primärseite (PS) und die Sekundärwicklung (Ns1) und der Ausgang (A1, A1') auf der Sekundärseite (SS) angeordnet sind;

   - wobei die Erfassungsschaltung (2) umfasst:

     - einen Erfassungstransformator (T2) mit einer Primärseite mit einer Erfassungsprimärwicklung (Np2) und einer Sekundärseite mit einer Erfassungssekundärwicklung (Ns2),

       wobei die Erfassungsprimärwicklung (Np2) auf der Sekundärseite des Transformators (T1) der synchronen Sperrwandlerschaltung und mit dem Ausgang der synchronen Sperrwandlerschaltung (A1, A1') in Reihe elektrisch verbunden ist, und
wobei der Erfassungstransformator (T2) derart eingerichtet ist, dass der Erfassungstransformator (T2) durch den Leuchtmittelstrecken-Strom ($i_{LED}$) in Sättigung betrieben wird;

- eine Stromquelle (StQ), die zum Einspeisen eines sich periodisch verändernden Stroms ($i_c$) in die Erfassungssekundärwicklung (Ns2) eingerichtet ist; und
- eine Signalerzeugungseinheit ($K_1$, K2, FF) zur Erzeugung des Signals;

- wobei der Erfassungstransformator (T2) derart eingerichtet ist, dass zum Zeitpunkt, zu dem die Sättigung des Erfassungstransformators (T2) aufgrund des sich periodisch verändernden Stroms ($i_c$) aufgehoben wird, ein Erfassungsimpuls (Imp1, Imp2) an die Erfassungssekundärwicklung (Ns2) übertragen wird;
- wobei die Signalerzeugungseinheit ($K_1$, K2, FF) dazu eingerichtet ist, die relative zeitliche Lage wenigstens zweier Erfassungsimpulse (Impi, Imp2) in einer Periode des sich periodisch verändernden Stroms ($i_c$) als Information bezüglich des Leuchtmittelstrecken-Stroms ($i_{LED}$) zur Erzeugung des Signals ($S_Q$) auszuwerten.

2. Synchrone Sperrwandlerschaltung (1) gemäß Anspruch 1,

- wobei die Stromquelle (StQ) zum Einspeisen eines sich periodisch verändernden Stroms ($i_c$) mit einer steigenden Flanke und einer fallenden Flanke während der Periode in die Erfassungssekundärwicklung (Ns2) eingerichtet ist; und
- wobei der Erfassungstransformator (T2) derart eingerichtet ist,

- dass während einer steigenden Flanke ein erster Erfassungsimpuls (Impi) an die Erfassungssekundärwicklung (Ns2) zum Zeitpunkt übertragen wird, zu dem die Sättigung des Erfassungstransformators (T2) aufgrund des sich periodisch verändernden Stroms ($i_c$) aufgehoben wird, und
- dass während einer fallenden Flanke ein zweiter Erfassungsimpuls (Imp2) an die Erfassungssekundärwicklung (Ns2) zum Zeitpunkt übertragen wird, zu dem die Sättigung des Erfassungstransformators (T2) aufgrund des sich periodisch verändernden Stroms ($i_c$) aufgehoben wird,

- vorzugsweise, wobei sich der erste Erfassungsimpuls (Imp1) und der zweite Erfassungsimpuls (Imp2) hinsichtlich ihrer Polarität unterscheiden.

3. Synchrone Sperrwandlerschaltung (1) gemäß Anspruch 2,

- wobei die Signalerzeugungseinheit ($K_1$, K2, FF) dazu eingerichtet ist, auf der Basis des während der Periode des sich periodisch verändernden Stroms übertragenen ersten Erfassungsimpuls (Imp1) und zweiten Erfassungsimpuls (Imp2) als Signal ($S_Q$) ein Signal mit zwei Signalpegeln zu erzeugen, wobei sich

- zum Zeitpunkt des Auftretens des ersten Erfassungsimpulses (Imp1) das Signal von einem ersten Signalpegel zu einem zweiten Signalpegel ändert, und
- zum Zeitpunkt des Auftretens des zweiten Erfassungsimpulses (Imp2) das Signal von dem zweiten Signalpegel zu dem ersten Signalpegel ändert,

- vorzugsweise, wobei der Tastgrad des durch die Signalerzeugungseinheit ($K_1$, K2, FF) erzeugten Signals ($S_Q$) ein Maß für den Leuchtmittelstrecken-Strom ($i_{LED}$) ist,
- wobei, weiterhin vorzugsweise, je größer der Tastgrad des durch die Signalerzeugungseinheit ($K_1$, K2, FF) erzeugten Signals ($S_Q$) desto niedriger ist der Leuchtmittelstrecken-Strom ($i_{LED}$).

4. Synchrone Sperrwandlerschaltung (1) gemäß einem der Ansprüche 2 oder 3,

- wobei die Erfassungsschaltung (2) dazu eingerichtet ist, den während der Periode des sich periodisch verändernden Stroms ($i_c$) übertragenen ersten Erfassungsimpuls (Imp1) und zweiten Erfassungsimpuls (Imp2) pegelmäßig derart zu ändern, dass der während der Periode des sich periodisch verändernden Stroms ($i_c$) übertragene erste Erfassungsimpuls (Imp1) und zweite Erfassungsimpuls (Imp2) in positive Spannungsimpulse umgesetzt werden, wobei der Pegel des dem ersten Erfassungsimpuls (Imp1) entsprechenden Spannungsimpulses höher als der Pegel des dem zweiten Erfassungsimpuls (Imp2) entsprechenden Spannungsimpulses ist.

5. Synchrone Sperrwandlerschaltung (1) gemäß einem der Ansprüche 2 bis 4,

- wobei die Signalerzeugungseinheit (K1, K2, FF) zwei Komparatoren (K1, K2) aufweist, die mit der Erfassungssekundärwicklung (Ns2) elektrisch verbunden sind,

- wobei ein erster Komparator (K1) der zwei Komparatoren (K1, K2) zur Erzeugung eines ersten Komparatorimpulses zum Zeitpunkt des Auftretens des ersten Erfassungsimpulses (Imp1) an der Erfassungssekundärwicklung (Ns2) eingerichtet ist, und
- wobei ein zweiter Komparator (K2) der zwei Komparatoren (K1, K2) zur Erzeugung eines zweiten Komparatorimpulses zum Zeitpunkt des Auftretens des zweiten Erfassungsimpulses (Imp2) an der Erfassungssekundärwicklung (Ns2) eingerichtet ist,

vorzugsweise:

- wobei die Signalerzeugungseinheit ($K_1$, $K_2$, FF) eine bistabile Kippstufe (FF) aufweist die mit den zwei Komparatoren (K1, K2) elektrisch verbunden ist;
- wobei der erste Komparator (K1) mit einem Setz-Eingang (S) der bistabilen Kippstufe (FF) und der zweite Komparator (K2) mit einem Rücksetz-Eingang (R) der bistabilen Kippstufe (FF) elektrisch verbunden ist; und
- wobei der nicht negierende Ausgang (Q) der bistabilen Kippstufe (FF) zum Ausgeben des Signals ($S_Q$) vorgesehen ist.

6.  Synchrone Sperrwandlerschaltung (1) gemäß einem der vorhergehenden Ansprüche,

    - wobei die synchrone Sperrwandlerschaltung (1) eine auf der Primärseite (PS) der synchronen Sperrwandlerschaltung (1) angeordnete Steuereinheit (3) zur Taktung des steuerbaren Schalters (S1) und Steuerung der Stromquelle (StQ) aufweist,
    - wobei die Steuereinheit (1) die Stromquelle (StQ) derart steuert, dass die Frequenz des sich periodisch verändernden Stroms ($i_c$) größer als die Frequenz der Taktung des steuerbaren Schalters (S1) ist.

7.  Synchrone Sperrwandlerschaltung (1) gemäß einem der vorhergehenden Ansprüche,

    - wobei der sich periodisch verändernde Strom ($i_c$) ein Dreieckstrom ist.

8.  Synchrone Sperrwandlerschaltung (1) gemäß einem der vorhergehenden Ansprüche,

    - wobei die Stromquelle (StQ) wenigstens einen Bipolartransistor zur Ausgabe des sich periodisch verändernden Stroms ($i_c$) aufweist.

9.  Synchrone Sperrwandlerschaltung (1) gemäß einem der vorhergehenden Ansprüche,

    - wobei die synchrone Sperrwandlerschaltung (1) wenigstens eine Impulsverbreiterungsschaltung (6) mit einer Parallelschaltung aus einem Kondensator (C2) und einen ohmschen Widerstand (R2) und mit einem dritten Komparator (K3) aufweist,
    - wobei der Kondensator (C2) und der ohmsche Widerstand (R2) derart eingerichtet sind, dass der Kondensator (C2) durch einen der Impulsverbreiterungsschaltung (6) zugeführten Impuls ($U_{in}$) während der Dauer des Impulses (Uin) geladen wird, um anschließend über den ohmschen Widerstand (R2) wieder entladen zu werden, wobei der Entladevorgang länger als der Ladevorgang dauert,
    - wobei der dritte Komparator (K3) dazu eingerichtet ist, die an der Parallelschaltung abfallende Spannung (Urc) mit einem Referenzspannungswert (ref_ext) zu vergleichen, der derart kleiner als der Maximalwert der Aufladung des Kondensators ($C_2$) gewählt ist, dass der durch den dritten Komparator (K3) ausgegebene Ausgangsimpuls (Uout), während die Spannung (Urc) an der Parallelschaltung den Referenzspannungswert (ref_ext) überschreitet, gegenüber dem zugeführten Impuls (Uin) verbreitert ist,
    - vorzugsweise, wobei je niedriger der Referenzspannungswert (ref_ext) gewählt ist, desto breiter ist der Ausgangsimpuls (Uout) im Vergleich zum zugeführten Impuls (Uin).

10. Synchrone Sperrwandlerschaltung (1) gemäß den Anspruch 9 rückbezogen auf Anspruch 5,

    - wobei der erste Komparator (K1) und/oder der zweite Komparator (K2) über die Impulsverbreiterungsschaltung (6) mit der Erfassungssekundärwicklung (Ns2) elektrisch verbunden ist; und/oder
    - wobei der erste Komparator (K1) und/oder der zweite Komparator (K2) über die Impulsverbreiterungsschaltung (6) mit der bistabilen Kippstufen (FF) elektrisch verbunden ist.

11. Synchrone Sperrwandlerschaltung (1) gemäß einem der vorhergehenden Ansprüche, wobei

    - die synchrone Sperrwandlerschaltung auf einer Leiterplatte angeordnet ist;
    - wobei der Erfassungstransformator (T2) einen Kern (7), insbesondere einen Ringkern, zur Übertragung von elektrischer Energie ausgehend von der Erfassungsprimärwicklung (Np2) zur Erfassungssekundärwicklung (Ns2) aufweist, und

- der Kern (7) sowie ein Teil der Wicklungen der Erfassungsprimärwicklung (Np2) und der Erfassungssekundärwicklung (Ns2) in eine Vertiefung der Leiterplatte eingelegt sind,

vorzugsweise:

- wobei wenigstens eine Kurzschlussbrücke (8) auf der Erfassungsprimärwicklung (Np2) und/oder der Erfassungssekundärwicklung (Ns2) angeordnet ist, und
- das Wicklungsverhältnis zwischen der Erfassungsprimärwicklung (Np2) und der Erfassungssekundärwicklung (Ns2) durch die wenigstens eine Kurzschlussbrücke (8) einstellbar ist.

12. Synchrone Sperrwandlerschaltung (1) gemäß Anspruch 11, wobei

- die wenigstens eine Kurzschlussbrücke (8) dazu eingerichtet ist, den in der Vertiefung der Leiterplatte angeordneten Teil der Wicklungen der Erfassungsprimärwicklung (Np2) und/oder der Erfassungssekundärwicklung (Ns2) zu schließen, wodurch die Wicklungszahl der Erfassungsprimärwicklung (Np2) und/oder der Erfassungssekundärwicklung (Ns2) entsprechend erhöht werden kann.

13. Synchrone Sperrwandlerschaltung (1) gemäß Anspruch 11, wobei

- der Kern (7) des Erfassungstransformators in der Leiterplatte vollkommen integriert ist, und
- wenigstens eine Leiterbahn (9) auf der Erfassungsprimärwicklung (Np2) und/oder der Erfassungssekundärwicklung (Ns2) angeordnet ist, und
- das Wicklungsverhältnis zwischen der Erfassungsprimärwicklung (Np2) und der Erfassungssekundärwicklung (Ns2) durch die wenigstens eine Leiterbahn (9) vorzugsweise einstellbar ist,
- wobei vorzugsweise die wenigstens eine Leiterbahn (9) dazu eingerichtet ist, Wicklungen der Erfassungsprimärwicklung (Np2) und/oder der Erfassungssekundärwicklung (Ns2) zu schließen, wodurch die Wicklungszahl der Erfassungsprimärwicklung (Np2) oder der Erfassungssekundärwicklung (Ns2) entsprechend erhöht werden kann.

14. Leuchte mit

- einer synchronen Sperrwandlerschaltung (1) gemäß einem der vorhergehenden Ansprüche, und

- einer Leuchtmittelstrecke (4) mit wenigstens einem Leuchtmittel (5), insbesondere mit wenigstens einer Leuchtdiode;
- wobei die synchrone Sperrwandlerschaltung (1) dazu eingerichtet ist, ausgehend von einer eingangsseitig zugeführten Eingangsspannung eine Ausgangsspannung zum Betrieb der Leuchtmittelstrecke (4) ausgangsseitig bereitzustellen.

15. Verfahren zum Erfassen des Leuchtmittelstrecken-Stroms ($i_{LED}$) bei einer synchrone Sperrwandlerschaltung (1) gemäß einem der Ansprüche 1 bis 13, wenn die Leuchtmittelstrecke (4) an die Sekundärwicklung (Ns1) des Transformators (T1) der synchronen Sperrwandlerschaltung (1) angeschlossen ist, wobei das Verfahren die folgenden Schritte umfasst:

- Einspeisen, mit der Stromquelle (StQ), eines sich periodisch verändernden Stroms ($i_c$) in die Erfassungssekundärwicklung (Ns2);
- Übertragen, mit dem Erfassungstransformator (T2), eines Erfassungsimpulses (Imp1, Imp2) an die Erfassungssekundärwicklung (Ns2) zum Zeitpunkt, zu dem die Sättigung des Erfassungstransformators (T2)) aufgrund des sich periodisch verändernden Stroms ($i_c$) aufgehoben wird; und
- Auswerten, mit der Signalerzeugungseinheit (2), der relativen zeitlichen Lage wenigstens zweier Erfassungsimpulse (Impi, Imp2) in einer Periode des sich periodisch verändernden Stroms ($i_c$) als Information bezüglich des Leuchtmittelstrecken-Stroms ($i_{LED}$) zur Erzeugung des Signals ($S_Q$).

**Claims**

1. Synchronous flyback converter circuit (1) for operating an illuminant line (4) comprising at least one illuminant (5), in particular comprising at least one light-emitting diode, wherein the synchronous flyback converter circuit (1) comprises:

- a transformer (T1) having a primary winding (Np1) which is electrically connected to a controllable switch (S1), and a secondary winding (Ns1) to which the illuminant line (4) can be connected via an output (A1, A1') of the synchronous flyback converter circuit (1), and
- a detection circuit (2) for generating a signal ($S_Q$) representing the illuminant line current ($i_{LED}$) flowing through the illuminant line (4) when the illuminant line (4) is connected to the secondary winding (Ns1);

- wherein the transformer (T1) galvanically isolates a primary side (PS) of the synchronous flyback converter circuit (1) and a secondary side (SS) of the synchronous flyback converter circuit (1) from one another;
- wherein the primary winding (Np1), the controllable switch (S1), and the detection circuit (2) are arranged on the primary side (PS), and the secondary winding (Ns1) and the output (A1, A1') are arranged on the secondary side (SS); wherein the detection circuit (2) comprises:

- a detection transformer (T2) comprising a primary side having a detection primary winding (Np2) and a secondary side having a detection secondary winding (Ns2),
- wherein the detection primary winding (Np2) on the secondary side of the transformer (T1) of the synchronous flyback converter circuit, and is electrically connected in series with the output of the synchronous flyback converter circuit (A1, A1'), and
- wherein the detection transformer (T2) is designed in such a way that the detection transformer (T2) is operated in saturation by the illuminant line current ($i_{iLED}$);
- a current source (StQ) which is designed to supply a periodically changing current ($i_c$) to the detection secondary winding (Ns2); and
- a signal generating unit (K1, K2, FF) for generating the signal; -wherein the detection transformer (T2) is designed in such a way that a detection pulse (Imp1, Imp2) is transmitted to the detection secondary winding (Ns2) at the point in time at which the saturation of the detection transformer (T2) is canceled due to the periodically changing current ($i_c$);
- wherein the signal generating unit (K1, K2, FF) is designed to evaluate the relative temporal position of at least two detection pulses (Imp1, Imp2) in a period of the periodically changing current ($i_c$) as information relating to the illuminant line current ($i_{LED}$) for generating the signal ($S_Q$).

2. Synchronous flyback converter circuit (1) according to claim 1,

- wherein the current source (StQ) is designed to supply a periodically changing current ($i_c$) having a rising edge and a falling edge to the detection secondary winding (Ns2) during the period; and
- wherein the detection transformer (T2) is designed in such a way that
- during a rising edge, a first detection pulse (Imp1) is transmitted to the detection secondary winding (Ns2) at the point in time at which the saturation of the detection transformer (T2) is canceled due to the periodically changing current ($i_c$), and
- during a falling edge, a second detection pulse (Imp2) is transmitted to the detection secondary winding (Ns2) at the point in time at which the saturation of the detection transformer (T2) is canceled due to the periodically changing current ($i_c$),
- wherein the first detection pulse (Imp1) and the second detection pulse (Imp2) preferably differ in polarity.

3. Synchronous flyback converter circuit (1) according to claim 2,

- wherein the signal generating unit (K1, K2, FF) is designed to generate, as signal ($S_Q$), a signal having two signal levels on the basis of the first detection pulse (Imp1) and second detection pulse (Imp2) transmitted during the period of the periodically changing current, wherein
- at the time of occurrence of the first detection pulse (Imp1), the signal changes from a first signal level to a second signal level, and
- at the time of occurrence of the second detection pulse (Imp2), the signal changes from the second signal level to the first signal level,
- preferably, wherein the duty factor of the signal ($S_Q$) generated by the signal generating unit (K1, K2, FF) is a measure of the illuminant line current ($i_{iLED}$), wherein, further preferably, the greater the duty factor of the signal ($S_Q$) generated by the signal generating unit (K1, K2, FF), the lower the illuminant line current ($i_{iLED}$).

4. Synchronous flyback converter circuit (1) according to either claim 2 or claim 3,

- wherein the detection circuit (2) is designed to change the level of the first detection pulse (Imp1) and second detection pulse (Imp2) transmitted during the period of the periodically changing current ($i_c$) in such a way that the first detection pulse (Imp1) and second detection pulse (Imp2) transmitted during the period of the periodically changing current ($i_c$) are converted into positive voltage pulses, wherein the level of the voltage pulse which corresponds to the first detection pulse (Imp1) is higher than the level of the voltage pulse which corresponds to the second detection pulse (Imp2).

5. Synchronous flyback converter circuit (1) according to any of claims 2 to 4,

- wherein the signal generating unit (K1, K2, FF) comprises two comparators (K1, K2) which are electrically connected to the detection secondary winding (Ns2),
- wherein a first comparator (K1) of the two comparators (K1, K2) is designed to generate a first comparator pulse at the time of occurrence of the first detection pulse (Imp1) at the detection secondary winding (Ns2), and
- wherein a second comparator (K2) of the two comparators (K1, K2) is designed to generate a second comparator pulse at the time of occurrence of the second detection pulse (Imp2) at the detection secondary winding (Ns2), preferably:

> - wherein the signal generating unit (K1, K2, FF) comprises a bistable flip-flop (FF) which is electrically connected to the two comparators (K1, K2);
> - wherein the first comparator (K1) is electrically connected to a set input (S) of the bistable flip-flop (FF) and the second comparator (K2) is electrically connected to a reset input (R) of the bistable flip-flop (FF); and
> - wherein the non-negating output (Q) of the bistable flip-flop (FF) is provided for outputting the signal ($S_Q$).

6. Synchronous flyback converter circuit (1) according to any of the preceding claims,

> - wherein the synchronous flyback converter circuit (1) comprises a control unit (3) arranged on the primary side (PS) of the synchronous flyback converter circuit (1) for clocking the controllable switch (S1) and controlling the current source (StQ),
> - wherein the control unit (1) controls the current source (StQ) in such a way that the frequency of the periodically changing current ($i_c$) is greater than the frequency of the clocking of the controllable switch (S1).

7. Synchronous flyback converter circuit (1) according to any of the preceding claims,

> - wherein the periodically changing current ($i_c$) is a delta current.

8. Synchronous flyback converter circuit (1) according to any of the preceding claims,

> - wherein the current source (StQ) comprises at least one bipolar transistor for outputting the periodically changing current ($i_c$).

9. Synchronous flyback converter circuit (1) according to any of the preceding claims,

> - wherein the synchronous flyback converter circuit (1) comprises at least one pulse broadening circuit (6) having a parallel circuit consisting of a capacitor (C2) and an ohmic resistor (R2), and having a third comparator (K3),
> - wherein the capacitor (C2) and the ohmic resistor (R2) are designed in such a way that the capacitor (C2) is charged by means of a pulse ($U_{in}$) supplied to the pulse broadening circuit (6) for the duration of the pulse (Uin) in order to be subsequently discharged again via the ohmic resistor (R2), the discharging process lasting longer than the charging process,
> - wherein the third comparator (K3) is designed to compare the voltage (Urc) dropping across the parallel circuit with a reference voltage value (ref_ext) which is selected to be smaller than the maximum value of the charge of the capacitor (C2) such that the output pulse (Uout) output by the third comparator (K3), while the voltage (Urc) across the parallel circuit exceeds the reference voltage value (ref_ext), is broadened relative to the supplied pulse (Uin),
> - preferably, wherein the lower the reference voltage value (ref_ext) selected, the wider the output pulse (Uout) is compared to the supplied pulse (Uin).

10. Synchronous flyback converter circuit (1) according to claim 9 with reference back to claim 5,

> - wherein the first comparator (K1) and/or the second comparator (K2) are electrically connected to the detection secondary winding (Ns2) via the pulse broadening circuit (6); and/or
> - wherein the first comparator (K1) and/or the second comparator (K2) are electrically connected to the bistable flip-flop (FF) via the pulse broadening circuit (6).

11. Synchronous flyback converter circuit (1) according to any of the preceding claims, wherein

> - the synchronous flyback converter circuit is arranged on a printed circuit board;
> - wherein the detection transformer (T2) has a core (7), in particular a toroidal core, for transmitting electrical energy from the detection primary winding (Np2) to the detection secondary winding (Ns2), and
> - the core (7) and a part of the windings of the detection primary winding (Np2) and the detection secondary winding (Ns2) are inserted into a recess in the printed circuit board, preferably:

- wherein at least one short-circuit bridge (8) is arranged on the detection primary winding (Np2) and/or the detection secondary winding (Ns2), and
- the winding ratio between the detection primary winding (Np2) and the detection secondary winding (Ns2) is adjustable by means of the at least one short-circuit bridge (8).

12. Synchronous flyback converter circuit (1) according to claim 11, wherein

- the at least one short-circuit bridge (8) is designed to close the part of the windings of the detection primary winding (Np2) and/or the detection secondary winding (Ns2) arranged in the recess in the printed circuit board, as a result of which the number of windings of the detection primary winding (Np2) and/or the detection secondary winding (Ns2) can be increased accordingly.

13. Synchronous flyback converter circuit (1) according to claim 11, wherein

- the core (7) of the detection transformer is fully integrated in the printed circuit board, and
- at least one conductor track (9) is arranged on the detection primary winding (Np2) and/or the detection secondary winding (Ns2), and the winding ratio between the detection primary winding (Np2) and the detection secondary winding (Ns2) is preferably adjustable by means of the at least one conductor track (9),
- wherein preferably the at least one conductor track (9) is designed to close windings of the detection primary winding (Np2) and/or the detection secondary winding (Ns2), as a result of which the number of windings of the detection primary winding (Np2) or the detection secondary winding (Ns2) can be increased accordingly.

14. Luminaire, comprising

- a synchronous flyback converter circuit (1) according to any of the preceding claims, and
- an illuminant line (4) comprising at least one illuminant (5), in particular comprising at least one light-emitting diode;
- wherein the synchronous flyback converter circuit (1) is designed to provide, on the output side, an output voltage for operating the illuminant line (4) from an input voltage supplied on the input side.

15. Method for detecting the illuminant line current ($i_{LED}$) in a synchronous flyback converter circuit (1) according to any of claims 1 to 13, when the illuminant line (4) is connected to the secondary winding (Ns1) of the transformer (T1) of the synchronous flyback converter circuit (1), the method comprising the steps of:

- feeding, by means of the current source (StQ), a periodically changing current ($i_c$) into the detection secondary winding (Ns2);
- transmitting, by means of the detection transformer (T2), a detection pulse (Imp1, Imp2) to the detection secondary winding (Ns2) at the point in time at which the saturation of the detection transformer (T2) is canceled due to the periodically changing current ($i_c$); and
- evaluating, by means of the signal generating unit (2), the relative temporal position of at least two detection pulses (Imp1, Imp2) in a period of the periodically changing current ($i_c$) as information relating to the illuminant line current ($i_{iLED}$) for generating the signal ($S_Q$).

## Revendications

1. Circuit de convertisseur à récupération synchrone (1) destiné à faire fonctionner une section de moyens d'éclairage (4) comportant au moins un moyen d'éclairage (5), en particulier comportant au moins une diode électroluminescente, le circuit de convertisseur à récupération synchrone (1) comprenant :

- un transformateur (T1) comportant un enroulement primaire (Np1), qui est connecté électriquement à un interrupteur commandable (S1), et un enroulement secondaire (Ns1), auquel la section de moyens d'éclairage (4) peut être connectée par l'intermédiaire d'une sortie (A1, A1') du circuit de convertisseur à récupération synchrone (1), et
- un circuit de détection (2) pour la génération d'un signal ($S_Q$) qui reflète le courant de la section de moyens d'éclairage ($i_{LED}$) qui circule à travers la section de moyens d'éclairage (4) lorsque la section de moyens d'éclairage (4) est connectée à l'enroulement secondaire (Ns1) ;
- le transformateur (T1) séparant galvaniquement un côté primaire (PS) du circuit de convertisseur à récupération synchrone (1) et un côté secondaire (SS) du circuit de convertisseur à récupération synchrone (1) ;
- l'enroulement primaire (Np1), l'interrupteur commandable (S1), et le circuit de détection (2) étant disposés sur le côté primaire (PS) et l'enroulement secondaire (Ns1) et la sortie (A1, A1') étant disposés sur le côté secondaire (SS) ;
- le circuit de détection (2) comprenant :

- un transformateur de détection (T2) comportant un côté primaire comportant un enroulement primaire de détection (Np2) et un côté secondaire comportant un enroulement secondaire de détection (Ns2),

l'enroulement primaire de détection (Np2) sur le côté secondaire du transformateur (T1) du circuit de convertisseur à récupération synchrone et étant connecté électriquement en série avec la sortie du circuit de convertisseur à récupération synchrone (A1, A1'), et le transformateur de détection (T2) étant conçu de telle sorte que le transformateur de détection (T2) est actionné à saturation par le courant de la section de moyen d'éclairage ($i_{LED}$) ;

- une source de courant (StQ) conçue pour l'alimentation d'un courant ($i_c$) variant périodiquement à l'enroulement secondaire de détection (Ns2) ; et
- une unité de génération de signal (K1, K2, FF) pour la génération du signal ;

- le transformateur de détection (T2) étant conçu de telle sorte qu'au moment où la saturation du transformateur de détection (T2) est supprimée en raison du courant ($i_c$) variant périodiquement, une impulsion de détection (Imp1, Imp2) est transmise à l'enroulement secondaire de détection (Ns2) ;
- l'unité de génération de signal (K1, K2, FF) étant conçue pour évaluer la position temporelle relative d'au moins deux impulsions de détection (Imp1, Imp2) dans une période du courant ($i_c$) variant périodiquement, en tant qu'information concernant le courant de la section de moyens d'éclairage ($i_{LED}$) pour la génération du signal ($S_Q$).

2. Circuit de convertisseur à récupération synchrone (1) selon la revendication 1,

- la source de courant (StQ) étant conçue pour l'alimentation d'un courant ($i_c$) variant périodiquement ayant un front montant et un front descendant pendant la période à l'enroulement secondaire de détection (Ns2) ; et
- le transformateur de détection (T2) étant conçu de telle sorte,

- que, pendant un front montant, une première impulsion de détection (Imp1) est transmise à l'enroulement secondaire de détection (Ns2) au moment où la saturation du transformateur de détection (T2) est supprimée en raison du courant ($i_c$) variant périodiquement, et
- que, pendant un front descendant, une seconde impulsion de détection (Imp2) est transmise à l'enroulement secondaire de détection (Ns2) au moment où la saturation du transformateur de détection (T2) est supprimée en raison du courant ($i_c$) variant périodiquement,

- de préférence, la première impulsion de détection (Imp1) et la seconde impulsion de détection (Imp2) différant en termes de leur polarité.

3. Circuit de convertisseur à récupération synchrone (1) selon la revendication 2,

- l'unité de génération de signal (K1, K2, FF) étant conçue pour générer, sur la base de la première impulsion de détection (Imp1) et de la seconde impulsion de détection (Imp2) transmises pendant la période du courant variant périodiquement, en tant que signal ($S_Q$), un signal ayant deux niveaux de signal,

- au moment de l'apparition de la première impulsion de détection (Imp1), le signal passant d'un premier niveau de signal à un second niveau de signal, et
- au moment de l'apparition de la seconde impulsion de détection (Imp2), le signal passant du second niveau de signal au premier niveau de signal,

- de préférence, le rapport cyclique du signal ($S_Q$) généré par l'unité de génération de signal (K1, K2, FF) étant une mesure du courant de section de moyens d'éclairage ($i_{LED}$),
- de préférence encore, plus le rapport cyclique du signal ($S_Q$) généré par l'unité de génération de signal (K1, K2, FF) est grand, plus le courant de section de moyens d'éclairage ($i_{LED}$) est faible.

4. Circuit de convertisseur à récupération synchrone (1) selon l'une des revendications 2 ou 3,

- le circuit de détection (2) étant conçu pour modifier le niveau de la première impulsion de détection (Imp1) et de la seconde impulsion de détection (Imp2) transmises pendant la période du courant ($i_c$) variant périodiquement de telle sorte que la première impulsion de détection (Imp1) et la seconde impulsion de détection (Imp2) transmises pendant la période du courant ($i_c$) variant périodiquement sont converties en impulsions de tension positives, le niveau de l'impulsion de tension correspondant à la première impulsion de détection (Imp1) étant supérieur au niveau de l'impulsion de tension correspondant à la seconde impulsion de détection (Imp2).

5. Circuit de convertisseur à récupération synchrone (1) selon l'une des revendications 2 à 4,

- l'unité de génération de signal (K1, K2, FF) présentant deux comparateurs (K1, K2) qui sont connectés électriquement à l'enroulement secondaire de détection (Ns2),
- un premier comparateur (K1) des deux comparateurs (K1, K2) étant conçu pour la génération d'une première impulsion de comparateur au moment de l'apparition de la première impulsion de détection (Imp1) sur l'enroulement secondaire de détection (Ns2), et
- un deuxième comparateur (K2) des deux comparateurs (K1, K2) étant conçu pour la génération d'une deuxième impulsion de comparateur au moment de l'apparition de la seconde impulsion de détection (Imp2) sur l'enroulement secondaire de détection (Ns2),
de préférence :

- l'unité de génération de signal (K1, K2, FF) présentant une bascule bistable (FF) qui est connectée électriquement aux deux comparateurs (K1, K2) ;
- le premier comparateur (K1) étant connecté électriquement à une entrée d'établissement (S) de la bascule bistable (FF) et le deuxième comparateur (K2) étant connecté électriquement à une entrée de remise à zéro (R) de la bascule bistable (FF) ; et
- la sortie non négative (Q) de la bascule bistable (FF) étant prévue pour la délivrance du signal ($S_Q$).

6. Circuit de convertisseur à récupération synchrone (1) selon l'une des revendications précédentes,

- le circuit de convertisseur à récupération synchrone (1) présentant une unité de commande (3) disposée sur le côté primaire (PS) du circuit de convertisseur à récupération synchrone (1) pour la synchronisation du commutateur commandable (S1) et la commande de la source de courant (StQ),
- l'unité de commande (1) commandant la source de courant (StQ) de telle sorte que la fréquence du courant ($i_c$) variant périodiquement est supérieure à la fréquence de synchronisation du commutateur commandable (S1).

7. Circuit de convertisseur à récupération synchrone (1) selon l'une des revendications précédentes,

- le courant ($i_c$) variant périodiquement étant un courant triangulaire.

8. Circuit de convertisseur à récupération synchrone (1) selon l'une des revendications précédentes,

- la source de courant (StQ) présentant au moins un transistor bipolaire pour délivrer le courant ($i_c$) variant périodiquement.

9. Circuit de convertisseur à récupération synchrone (1) selon l'une des revendications précédentes,

- le circuit de convertisseur à récupération synchrone (1) présentant au moins un circuit d'élargissement d'impulsion (6) comportant un circuit parallèle d'un condensateur (C2) et d'une résistance ohmique (R2) et comportant un troisième comparateur (K3),
- le condensateur (C2) et la résistance ohmique (R2) étant conçus de telle sorte que le condensateur (C2) est chargé par une impulsion ($U_{in}$) appliquée au circuit d'élargissement d'impulsion (6) pendant la durée de l'impulsion (Uin), pour être ensuite déchargé à nouveau par l'intermédiaire de la résistance ohmique (R2), le processus de décharge étant plus long que le processus de charge,
- le troisième comparateur (K3) étant conçu pour comparer la tension (Urc) chutant aux bornes du circuit parallèle à une valeur de tension de référence (ref_ext) qui est choisie inférieure à la valeur maximale de la charge du condensateur (C2) de telle sorte que l'impulsion de sortie (Uout) délivrée par le troisième comparateur (K3), tandis que la tension (Urc) aux bornes du circuit parallèle dépasse la valeur de tension de référence (ref_ext), est élargie par rapport à l'impulsion (Uin) fournie,
- de préférence, plus la valeur de tension de référence (ref_ext) est choisie basse, plus l'impulsion de sortie (Uout) est large par comparaison avec l'impulsion (Uin) fournie.

10. Circuit convertisseur à récupération synchrone (1) selon la revendication 9, en référence à la revendication 5,

- le premier comparateur (K1) et/ou le deuxième comparateur (K2) étant connecté électriquement à l'enroulement secondaire de détection (Ns2) par l'intermédiaire du circuit d'élargissement d'impulsion (6) ; et/ou
- le premier comparateur (K1) et/ou le deuxième comparateur (K2) étant connecté électriquement à la bascule bistable (FF) par l'intermédiaire du circuit d'élargissement d'impulsion (6).

11. Circuit de convertisseur à récupération synchrone (1) selon l'une quelconque des revendications précédentes, dans lequel

- le circuit de convertisseur à récupération synchrone est disposé sur une carte de circuit imprimé ;
- le transformateur de détection (T2) présentant un noyau (7), en particulier un noyau annulaire, pour la transmission d'énergie électrique à partir de l'enroulement primaire de détection (Np2) vers l'enroulement secondaire de détection (Ns2), et
- le noyau (7) ainsi qu'une partie des enroulements de l'enroulement primaire de détection (Np2) et de l'enroulement secondaire de détection (Ns2) sont insérés dans un renfoncement de la carte de circuit imprimé, de préférence :

- au moins un pont de court-circuit (8) étant disposé sur l'enroulement primaire de détection (Np2) et/ou l'enroulement secondaire de détection (Ns2), et
- le rapport d'enroulement entre l'enroulement primaire de détection (Np2) et l'enroulement secondaire de détection (Ns2) pouvant être réglé par l'au moins un pont de court-circuit (8).

**12.** Circuit de convertisseur à récupération synchrone (1) selon la revendication 11, dans lequel

- l'au moins un pont de court-circuit (8) est conçu pour fermer la partie des enroulements de l'enroulement primaire de détection (Np2) et/ou de l'enroulement secondaire de détection (Ns2) disposée dans le renfoncement de la carte de circuit imprimé, ce qui permet d'augmenter de manière correspondante le nombre d'enroulements de l'enroulement primaire de détection (Np2) et/ou de l'enroulement secondaire de détection (Ns2).

**13.** Circuit de convertisseur à récupération synchrone (1) selon la revendication 11, dans lequel

- le noyau (7) du transformateur de détection est entièrement intégré dans la carte de circuit imprimé, et
- au moins une piste conductrice (9) est disposée sur l'enroulement primaire de détection (Np2) et/ou l'enroulement secondaire de détection (Ns2),
- et le rapport d'enroulement entre l'enroulement primaire de détection (Np2) et l'enroulement secondaire de détection (Ns2) est de préférence réglable par l'au moins une piste conductrice (9),
- de préférence, l'au moins une piste conductrice (9) étant conçue pour fermer des enroulements de l'enroulement primaire de détection (Np2) et/ou de l'enroulement secondaire de détection (Ns2), ce qui permet d'augmenter de manière correspondante le nombre d'enroulements de l'enroulement primaire de détection (Np2) ou de l'enroulement secondaire de détection (Ns2).

**14.** Luminaire, comportant

- un circuit de convertisseur à récupération synchrone (1) selon l'une quelconque des revendications précédentes, et
- une section de moyens d'éclairage (4) comprenant au moins un moyen d'éclairage (5), en particulier comprenant au moins une diode électroluminescente ;
- le circuit de convertisseur à récupération synchrone (1) étant conçu pour fournir côté sortie, à partir d'une tension d'entrée fournie côté entrée, une tension de sortie pour faire fonctionner la section de moyens d'éclairage (4).

**15.** Procédé pour la détection du courant de section de moyens d'éclairage ($i_{LED}$) dans un circuit de conversion à récupération synchrone (1) selon l'une des revendications 1 à 13, lorsque la section de moyens d'éclairage (4) est connectée à l'enroulement secondaire (Ns1) du transformateur (T1) du circuit de conversion à récupération synchrone (1), le procédé comprenant les étapes suivantes :

- alimentation, avec la source de courant (StQ), d'un courant ($i_c$) variant périodiquement dans l'enroulement secondaire de détection (Ns2) ;
- transmission, avec le transformateur de détection (T2), d'une impulsion de détection (Imp1, Imp2) à l'enroulement secondaire de détection (Ns2) au moment où la saturation du transformateur de détection (T2) est supprimée en raison du courant ($i_c$) variant périodiquement ; et
- évaluation, avec l'unité de génération de signal (2), de la position temporelle relative d'au moins deux impulsions de détection (Imp1, Imp2) dans une période du courant ($i_c$) variant périodiquement, en tant qu'information concernant le courant de section de moyens d'éclairage ($i_{LED}$) pour la génération du signal ($S_Q$).

**Figur 1**

EP 3 815 469 B1

Figur 2

**Figur 3**

Figur 4A

Figur 4B

Figur 5B

Figur 5A

**Figur 6**

EP 3 815 469 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011037414 A1